(19) Europäisches Patentamt
European Patent Office
Office européen des brevets

(11) **EP 4 641 628 B1**

(12) **EUROPÄISCHE PATENTSCHRIFT**

(45) Veröffentlichungstag und Bekanntmachung des Hinweises auf die Patenterteilung:
**13.05.2026  Patentblatt 2026/20**

(21) Anmeldenummer: **25169658.9**

(22) Anmeldetag: **10.04.2025**

(51) Internationale Patentklassifikation (IPC):
***H10W 29/00*** *(2026.01)*

(52) Gemeinsame Patentklassifikation (CPC):
**H10W 72/0711;** H10W 72/07141; H10W 72/07331

(54) **ZYLINDERPLATTE EINER VORRICHTUNG ZUM VERBINDEN EINES BAUELEMENTS MIT EINEM SUBSTRAT**

CYLINDER PLATE OF A DEVICE FOR CONNECTING A COMPONENT TO A SUBSTRATE

PLAQUE CYLINDRIQUE D'UN DISPOSITIF DE CONNEXION D'UN COMPOSANT À UN SUBSTRAT

(84) Benannte Vertragsstaaten:
**AL AT BE BG CH CY CZ DE DK EE ES FI FR GB GR HR HU IE IS IT LI LT LU LV MC ME MK MT NL NO PL PT RO RS SE SI SK SM TR**

(30) Priorität:  **25.04.2024  AT 503442024**

(43) Veröffentlichungstag der Anmeldung:
**29.10.2025  Patentblatt 2025/44**

(73) Patentinhaber: **SMT Maschinen- und Vertriebs GmbH & Co. KG**
**97877 Wertheim (DE)**

(72) Erfinder:
• **Ulzhöfer, Christian**
**97877 Wertheim (DE)**
• **Eyrich, Tobias**
**97877 Wertheim (DE)**

(74) Vertreter: **TBK**
**Bavariaring 4-6**
**80336 München (DE)**

(56) Entgegenhaltungen:
EP-A1- 4 525 032          EP-B1- 2 954 550
WO-A1-2023/182885     DE-A1- 102017 216 545

**Beschreibung**

Die Erfindung betrifft eine Zylinderplatte einer Vorrichtung zum Verbinden eines Bauelements mit einem Substrat und eine solche Vorrichtung.

HINTERGRUND DER ERFINDUNG

Mit steigendem Bedarf der Elektronikindustrie an der Entwicklung effizienter und hochtemperaturbeständiger Bauelemente wie z.B. Chips, gewinnt das Sintern einer Verbindungsschicht zwischen Bauelement und Substrat an Popularität.

Sintern ist unter anderem als ein Verfahren zur Herstellung von Metallteilen oder Keramikteilen bekannt. Dabei entsteht durch Zusammenpressen eines pulverförmigen Ausgangsmaterials ein fein- oder grobkörniger Grünkörper, der bei einer anschließenden Temperaturbehandlung seine endgültige Form erhält und somit zu einem festen Werkstück wird.

Unter Sintern gemäß der Anmeldung und in der Herstellung und Verarbeitung von Bauelementen wie z.B. Halbleiter-Chips versteht man hier ein ähnliches Verfahren, ein Bauelement und ein Substrat unter Anwendung eines vorbestimmten Drucks und einer vorbestimmten Temperatur für eine gewisse Zeit zusammen zu drücken, wodurch eine Verbindung zwischen den beiden Elementen entsteht. Aktueller Stand der Technik ist der Einsatz von pastösen Materialien wie z.B. Silber- oder Kupferpaste oder auch nanostrukturierten Plättchen, die als Verbindung zwischen Chip und Substrat dienen, und durch die Druck- und Temperaturbeaufschlagung versintert werden. Ein solches Sintern als Verfahren zum Verbinden eines Bauelements mit einem Substrat ist bekannt und hat sich als vorteilhaft gegenüber bisher angewendeten Lötverfahren auf Zinn- oder Bleibasis erwiesen.

Für einen derartigen Sintervorgang sind bestimmte Parameter wie z.B. eine Einstelltemperatur, ein Druck und eine Haltezeit für die effektive Befestigung des Bauelements auf dem Substrat zu definieren. Ausgehend von Versuchen können diese Parameter je nach Anforderung ermittelt werden. Bei solchen Sintervorgängen kann auch vorteilhaft ein Bindemittel eingesetzt werden, das zwischen dem Bauelement und dem Substrat aufgebracht wird. Entsprechend kann die Schichtdicke des Bindemittels einen weiteren Parameter darstellen. Bevorzugt kann eine Silberpaste als derartiges Bindemittel eingesetzt werden.

Bevorzugt kommt es während eines Sintervorgangs nicht zu einer Phasenumwandlung des Bindemittels, z.B. einer Silberpaste, wie es in den Lötverfahren auf Zinn- und Bleibasis der Fall ist. Durch geeignete Temperatur- und Druckanwendung wird bewirkt, dass Partikel des Bindemittels in die Oberfläche des Substrats und des zu befestigenden Bauelements diffundieren. Dadurch entsteht eine Verbindung von Oberfläche zu Oberfläche anstatt einer Phasenwechselverbindung.

Zu einer wirksamen Befestigung ist eine parallele, gleichmäßige Kraftverteilung auf der Oberfläche des Bauelements erforderlich, und eine solche ist zu gewährleisten. Daher ist eine individuelle Kraftaufbringungskomponente eine von modernen Elektronikherstellern bevorzugte Lösung, die eine gute Qualität der Verbindung gewährleisten kann. Individuelle Kraftaufbringung bedeutet ein separates Werkzeug für jede Paarung aus Bauelement und Substrat. Dies kann hohe Werkzeugkosten verursachen.

Die Anwendung von Temperatur und Druck ist erforderlich, um eine wirksame Verbindung zwischen dem Bauelement und dem Substrat zu erreichen, andernfalls könnte die Qualität der Verbindung schlecht oder für praktische Zwecke zu langsam sein.

Das Prinzip des Verfahrens besteht nicht in einer Phasenumwandlung des Verbindungsmittels (z.B. Silberpaste), wie es bei Lötverfahren auf Zinn- und Bleibasis der Fall ist. Durch geeignete Temperatur- und Druckanwendung diffundieren Silberbestandteile in die Oberfläche des Substrats und des zu befestigenden Bauelements. Dadurch wird der Kontakt zu einer Oberfläche-Oberfläche-Verbindung und nicht zu einem Phasenwechselkontakt.

Für diese Art von Prozess werden allgemein auch die Ausdrücke "die attach" oder "die packaging" verwendet.

Die Druckschrift DE 10 2013 101 124 zeigt eine Vorrichtung und ein Verfahren eines Sinterprodukts. Das Sinterprodukt umfasst ein Bauelement und ein Substrat. Um diese zu verbinden wird das Sinterprodukt in eine Vorrichtung mit einem Presstisch und einem Pressstempel eingelegt. Durch eine Temperaturerhöhung mittels einer Heizeinrichtung wird eine Ausdehnung eines Druckkörpers in dem Pressstempel bewirkt, wodurch auf das Sinterprodukt ein Druck ausgeübt wird. Somit wird das Bauelement mit dem Substrat verbunden.

Die Druckschrift DE 10 2015 120 156 A1 offenbart eine Vorrichtung zur materialschlüssigen Verbindung von Verbindungspartnern eines Leistungselektronik-Bauteils. Hier wirkt ein formstabiler Rahmen auf einen der Verbindungspartner, während ein elastisches Kissen auf einen zweiten Verbindungspartner wirkt, um einen zum Verbinden erforderlichen Druck aufzubauen.

Die Druckschrift JP H11 - 121 532 A offenbart eine Sintervorrichtung, in der Kolben pneumatisch betätigt werden, um Druck auf ein zu sinterndes Produkt auszuüben.

Die Druckschrift EP 2 954 550 B1 offenbart eine Sintervorrichtung, in der mehrere Kolben in Zylinderbohrungen einer Zylinderplatte aufgenommen sind. Die Kolben können pneumatisch betätigt werden, um über Stempel einen Druck auf ein zu sinterndes Produkt zu übertragen.

Um die Kolben zu betätigen, muss ein Druckmedium über Druckzufuhrleitungen zu den Zylinderbohrungen zugeführt werden. Die Herstellung der Druckzufuhrleitungen erfolgt gemäß Stand der Technik durch Herstellen von Bohrlöchern von außerhalb der Zylinderplatte. Im Fall von umfangreicheren Leitungssystemen ist es dabei erforderlich, eine Vielzahl von Bohrlöchern zu fertigen, von denen alle bis auf einen Anschluss für das Druckmedium wieder zu verschließen sind. Im Fall von mehreren unterschiedlich zu betätigenden Kolben ist es außerdem erforderlich, die Druckzufuhrleitungen auf verschiedenen Höhenniveaus anzuordnen, da es keine Überschneidungen oder Kreuzungen der unterschiedlichen Druckzufuhrleitungen geben darf. Es ist nämlich denkbar, einzelne Kolben oder Kolbengruppen mit unterschiedlichen Drücken zu beaufschlagen.

Da die Anordnung der Druckzufuhrleitungen und Zylinderbohrungen von dem Design der zu erzeugenden Bauelemente abhängt, variieren der Ort und Durchmesser der Zylinderbohrungen sowie die Verläufe der Druckzufuhrleitungen sehr stark. Für jede neue Zylinderplatte ist es gemäß Stand der Technik für deren Herstellung erforderlich, verschiedene Werkzeuge einzurichten und die Maschine neu zu programmieren. Außerdem ist aufgrund von Festigkeitsgründen des Bohrwerkzeugs eine Herstellung von Bohrlöchern unter einem Mindestdurchmesser nicht möglich. Die Druckzufuhrleitungen weisen nämlich ein zum Bohren ungünstiges Längen-Durchmesserverhältnis auf.

Das Fertigen insbesondere von horizontalen Druckzufuhrleitungen kleinen Durchmessers ist sehr anspruchsvoll und führt häufig zu fehlerhaften Zylinderplatten, d.h. zu Ausschuss. Eine aufwendige Qualitätssicherung ist daher unabdingbar.

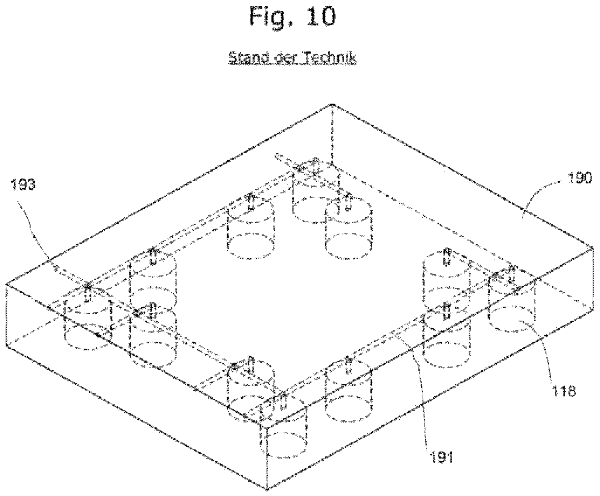

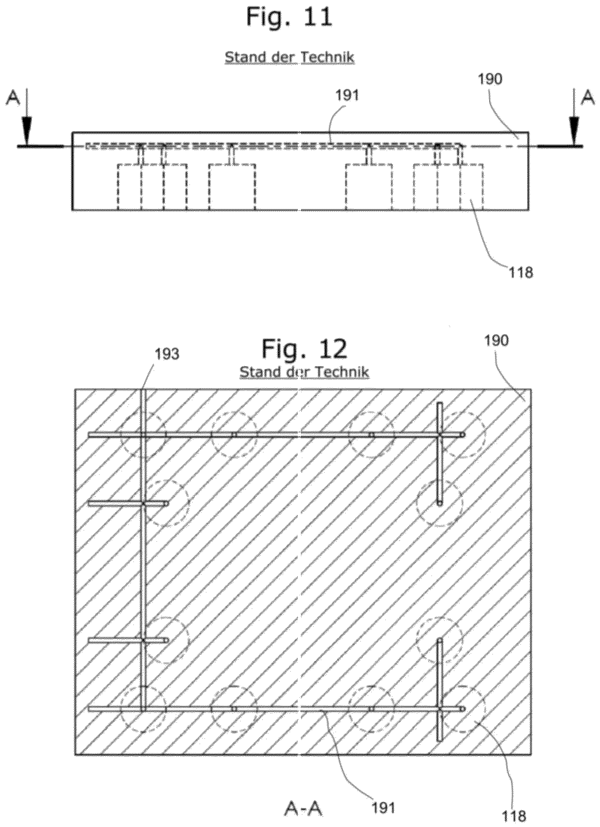

Beispiele für diesen nicht druckschriftlich belegten Stand der Technik sind aus den Figs. 10 bis 12 und den Figs. 19, 20, 20a bis 20c ersichtlich. Dabei zeigen die Figs. 10 bis 12 eine Zylinderplatte 190 mit einer einzelnen Druckzufuhrleitung 191 zur Versorgung aller Zylinderbohrungen 118. Das Druckmedium wird über einen Anschluss 193 in die Druckzufuhrleitung eingebracht.

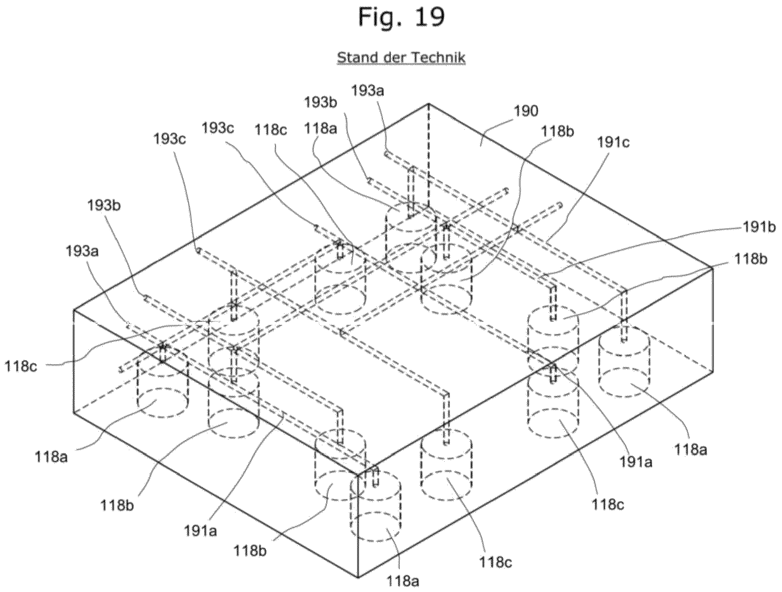

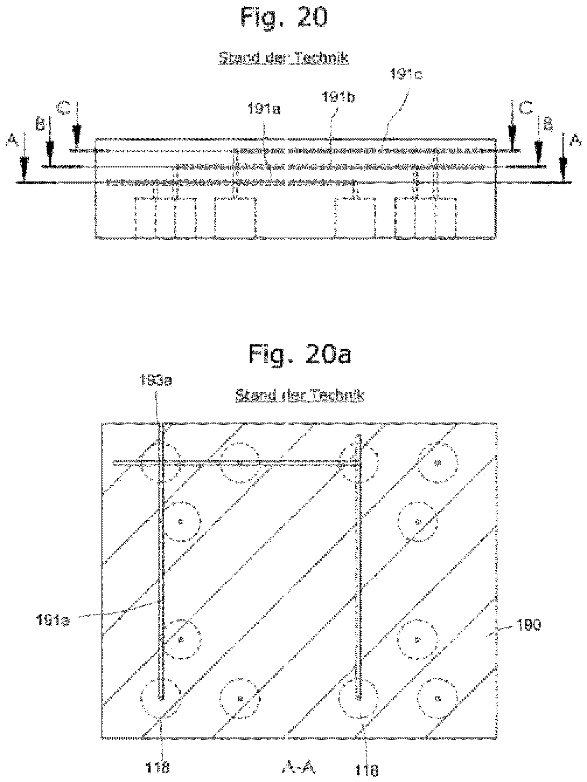

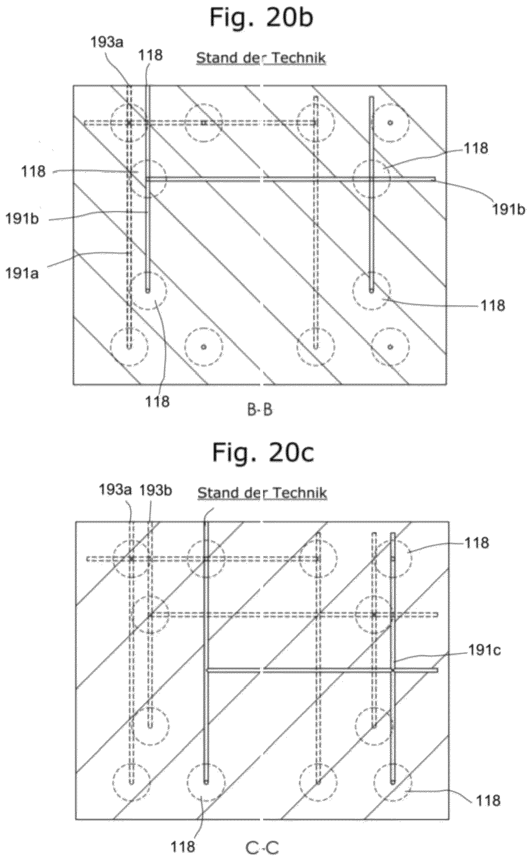

Die Figs. 19, 19, 20, 20a bis 20c zeigen eine Zylinderplatte 190, in der Zylinderbohrungen 118a, 118b und 118c in Gruppen jeweils über eine eigene Druckzufuhrleitung 191a, 191b und 191c mit Anschlüssen 193a, 193b und 193c versorgt werden. Damit es nicht zu Kreuzungen der einzelnen Leitungen kommt, sind die unterschiedlichen Druckzufuhrleitungen 191a, 191b und 191c jeweils in einer eigenen Ebene angeordnet, wie aus der Fig. 20 ersichtlich ist.

Es besteht Bedarf an einer verbesserten Zylinderplatte, die im Vergleich zum Stand der Technik einfacher zu fertigen und flexibler gestaltbar ist und an einer Vorrichtung zum Verbinden eines Bauelements mit einem Substrat mit einer solchen Zylinderplatte.

Eine erfindungsgemäße Zylinderplatte ist für eine Vorrichtung zum Verbinden eines Bauelements mit einem Substrat vorgesehen, die eine in zumindest zwei Teile teilbare Kammer hat. Die Zylinderplatte ist dabei an einem ersten Teil der Kammer vorgesehen. In der Zylinderplatte sind ausgebildet: eine Zylinderbohrung zur Aufnahme eines hin- und herbeweglichen Kolbens, der bei Beaufschlagung mit einem gasförmigen Druckmedium zur Druckübertragung mit einem Stempel in Anlage bringbar ist, um den Stempel gegen einen an einem zweiten Teil vorgesehenen Gegenstempel zu drücken, und eine Druckzufuhrleitung, über die zur Betätigung des Kolbens ein Druckmedium zu der Zylinderbohrung zuführbar ist. Die Zylinderplatte ist mittels additiver Fertigung hergestellt.

Überraschenderweise hat sich herausgestellt, dass trotz der schlechteren Materialeigenschaften einer mittels additiver Fertigung hergestellten Zylinderplatte die Materialkennwerte wie zum Beispiel Zugfestigkeit, Elastizitätsmodul usw. trotz des erforderlichen Eingangsdrucks zwischen 50 MPa und 60 MPa für den vorgesehenen Einsatz ausreichend sind. Daher stellt eine additiv gefertigte Zylinderplatte eine kostengünstig und vor allem flexibel zu fertigende Alternative zu einer Zylinderplatte gemäß dem Stand der Technik dar.

Die schlechteren Materialeigenschaften von gedrucktem Metall, wie niedrigere Zugfestigkeit, niedrigerer Elastizitätsmodul usw., können dadurch kompensiert werden, dass kleinere Leitungsdurchmessern und damit eine dünnere Wandstärke als bei herkömmlich gefertigten Zylinderplatten möglich sind. Darüber hinaus stellt die sehr große Gestaltungsfreiheit der Druckzufuhrleitungen einen weiteren Vorteil der erfindungsgemäßen Zylinderplatte dar.

Vorteilhaft kann in der erfindungsgemäßen Zylinderplatte eine Vielzahl Zylinderbohrungen mit darin aufgenommenen hin-und herbeweglichen Kolben vorgesehen sein. Jede Zylinderbohrung kann über eine in der Zylinderplatte ausgebildete Druckzufuhrleitung mit einem Druckmedium versorgt werden.

Somit ist es möglich, jede einzelne Zylinderbohrung unabhängig von den anderen Zylinderbohrungen mit dem Druckmedium zu versorgen. Es ist aber genauso gut möglich, alle Zylinderbohrungen zugleich über die in der Zylinderplatte ausgebildete Druckzufuhrleitung mit dem Druckmedium zu versorgen.

In der erfindungsgemäßen Zylinderplatte kann eine Vielzahl Zylinderbohrungen vorgesehen sein, und einzelne Zylinderbohrungen können zu Gruppen zusammengefasst sein. Zylinderbohrungen einer Gruppe können dabei über eine eigene in der Zylinderplatte ausgebildete Druckzufuhrleitung mit einem Druckmedium versorgt werden.

Somit können je nach Anforderung der zu sinternden Bauteile einzelne Gruppen definiert werden, und die Bauteile mit unterschiedlichen Drücken beaufschlagt werden.

Vorteilhaft können in der erfindungsgemäßen Zylinderplatte mehrere Druckzufuhrleitungen in einer einzigen Ebene der Zylinderplatte vorgesehen sein. Schnitte oder Kreuzungen von zwei unterschiedlichen Druckzufuhrleitungen werden dabei durch Umgehen der ersten Druckzufuhrleitung durch die zweite Druckzufuhrleitung über eine zweite Ebene vermieden.

Entsprechend ist es möglich, die Zylinderplatte im Vergleich zu dem Stand der Technik mit einer geringen Dicke auszuführen, da es nicht notwendig ist, jede Druckzufuhrleitung in einer eigenen Ebene vorzusehen.

Zumindest ein Abschnitt der Druckzufuhrleitung kann von einer geradlinigen Form abweichend ausgebildet sein.

Durch die additive Fertigung ist es möglich, nicht nur gerade Druckzufuhrleitungen herzustellen, sondern diese können im dreidimensionalen Raum beliebig gekrümmt sein. Somit ist es möglich, einen Anschluss für das Druckmedium auf kürzestem Weg mit einer entsprechenden Zylinderbohrung zu verbinden.

Bevorzugt können die Druckzufuhrleitungen einen kreisförmigen Querschnitt aufweisen. Es ist aber ebenso gut möglich, einen von einer Kreisform abweichenden Querschnitt wie zum Beispiel viereckig, polygonförmig, elliptisch oder auch sternförmig zu fertigen

Die Druckzufuhrleitung kann vorteilhaft einen Durchmesser zwischen 0,1 mm und 4 mm aufweisen. Bevorzugt beträgt der Durchmesser zwischen 0,1 mm und 1 mm.

Es ist nämlich aufgrund der additiven Fertigung möglich, die Durchmesser der Druckzufuhrleitungen viel geringer auszuführen, als dies in dem Stand der Technik möglich ist. Dies ist deswegen sehr vorteilhaft, da aufgrund der somit reduzierten Mantelfläche einer dünnen Druckzufuhrleitung die auf die Zylinderplatte wirkende Druckkraft verringert ist. Somit können die Wandstärken insgesamt geringer ausgelegt werden, was Bauraum und Material einspart.

Vorteilhaft kann die Zylinderplatte aus Aluminium oder einer Aluminiumlegierung gefertigt sein.

Vorteilhaft kann die Zylinderplatte mehrere Teile umfassen.

Dies erleichtert die Herstellung, da eine Druckvorrichtung für die additive Fertigung kleiner ausgeführt sein kenn. Aber selbst für nicht additive gefertigte Zylinderplatten gemäß Stand der Technik ist eine derartige Teilung vorteilhaft, da die Bohrungen einfacher gefertigt werden können.

Bevorzugt sind vier Teile, allerdings kann die Anzahl der mehreren Teile von zwei aufwärts beliebig groß gewählt werden.

Vorteilhaft kann die Zylinderplatte in Randbereichen Löcher zur Lagerung über Stifte an einem Oberteil einer Vorrichtung zum Verbinden eines Bauelements mit einem Substrat aufweisen.

Vorteilhaft kann die Zylinderplatte an ihren Anbindungsflächen über Stifte, oder andere formschlüssige Verbindungstechniken, mit der Kammer und/oder der Stempelplatte verbunden sein. Dabei ist an einer Seite der jeweiligen Verbindungmechanik eine eindimensionale Verschiebung, in der Ebene der entsprechenden Anbindungsfläche vorgesehen. Für einen Zylinderstift könnte dies zum Beispiel als ein Langloch ausgeführt sein.

Als Anbindungsfläche ist der Bereich der Zylinderplatte definiert, in dem sie in Berührung mit benachbarten Elementen wie z.B. dem Oberteil der Kammer oder der Stempelplatte gerät oder mit den benachbarten Elementen verbunden ist.

Somit ist eine genaue Positionierung der Zylinderplatte über die Löcher und die Stifte möglich. Dies ist besonders vorteilhaft bei einer mehrteiligen Zylinderplatte, da die einzelnen Teile so fixiert werden können.

Vorteilhaft können die Löcher als Langlöcher ausgeführt sein, deren Längsachse auf einer Linie liegt, die die jeweilige Anbindungsfläche der Zylinderplatte mit einem Nullpunkt (A) der Zylinderplatte oder einem Stoßpunkt von mehreren Teilen der Zylinderplatte verbindet.

Als Stoßpunkt ist hier ein Punkt definiert, in dem in einem Fall einer mehrteiligen Zylinderplatte die mehreren Teile aneinander anliegen. Als Nullpunkt ist ein Punkt definiert, der einem Mittelpunkt der Zylinderplatte oder eines Teils der Zylinderplatte entspricht. Der Nullpunkt hat dabei die Eigenschaft, dass er aufgrund der Lagerung der Zylinderplatte über die Löcher im Fall einer Wärmedehnung keiner Positionsänderung unterliegt.

Die Längsachsen der im Fall von Langlöchern oder Schlitzen eindimensionalen Verschiebungsmechaniken spannen an einem Schnittpunkt ihrer Achsen einen Nullpunkt des jeweiligen Verbindungssystems auf. Die Richtung der Längsachsen in der Anbindungsfläche kann dabei frei gewählt werden. Dabei ist zu beachten, dass mindestens eine Längsachse nicht parallel zu den anderen liegt.

Eine erfindungsgemäße Vorrichtung zum Verbinden eines Bauelements mit einem Substrat hat eine in zumindest zwei Teile teilbare Kammer. An einem ersten Teil ist in Stempel vorgesehen, und an einem zweiten Teil ist ein Gegenstempel vorgesehen. Das erste Teil ist mit dem zweiten Teil in Anlage bringbar, um die Kammer zu schließen. Der Gegenstempel ist in einem geöffneten Zustand der Kammer mit Ausgangsstoffen beschickbar. In einem geschlossenen Zustand der Kammer ist über den Stempel ein Druck auf die zwischen dem Stempel und dem Gegenstand vorgesehenen Ausgangsstoffe ausübbar. An dem ersten Teil ist eine Zylinderplatte vorgesehen, die voranstehend beschrieben wurde. Der Druck des Druckmediums in der Druckzufuhrleitung wird mittels einem Kolben auf den Stempel übertragen.

Bei dem Druckmedium handelt es sich bevorzugt um ein Gas.

Die Erfindung betrifft auch ein Verfahren zur Fertigung einer Zylinderplatte die Zylinderbohrungen aufweist, die über eine Druckzufuhrleitung mit einem Anschluss in Verbindung sind. Die Zylinderplatte wird durch schichtweises Auftragen eines sich nach dem Auftragen verfestigenden Materials auf eine Fertigungsfläche additiv gefertigt. Dabei werden die Zylinderbohrungen und die Druckzufuhrleitungen beim Auftragen des Materials ausgespart.

Vorteilhaft können die Druckzufuhrleitungen dabei in einer einzigen Ebene der Zylinderplatte liegen, und Schnitte oder Kreuzungen von zwei unterschiedlichen Druckzufuhrleitungen werden durch Umgehen von einer Druckzufuhrleitung durch die andere Druckzufuhrleitung über eine zweite Ebene gefertigt.

Entsprechend ist es möglich, mehrere Zylindergruppen vorzusehen, die jeweils mit unterschiedlichen Drücken und/oder zu unterschiedlichen Zeiten beaufschlagt werden. Dadurch, dass bis auf die Kreuzungen von zwei Leitungen, wo auf eine zweite Ebene ausgewichen wird, alle Leitungen in einer einzigen Ebene liegen, kann die Zylinderplatte mit einer reduzierten Dicke gestaltet werden.

KURZE BESCHREIBUNG DER FIGUREN

Weitere Vorteile der Erfindung werden auch aus der folgenden Beschreibung anhand der Figuren deutlich, die ein derzeit bevorzugtes Ausführungsbeispiel zeigen.

Fig. 1 zeigt eine erfindungsgemäße Vorrichtung zum Verbinden eines Bauelements mit einem Substrat in einem geöffneten Zustand.

Fig. 2a zeigt eine Seitenansicht eines Formschlussmechanismus gemäß einer ersten Ausführungsform der Erfindung, und Fig. 2b zeigt eine Schnittansicht der Fig. 2a.

Fig. 3a zeigt eine Schnittansicht des Formschlussmechanismus gemäß der ersten Ausführungsform in einem geschlossenen Zustand der Vorrichtung unter Last, und Fig. 3b zeigt eine Schnittansicht gemäß Fig. 3a in einem geschlossenen Zustand der Vorrichtung ohne Belastung.

Fig. 4a zeigt eine Modifikation gemäß Fig. 3a, die mit einer Dichtung versehen ist, und Fig. 4b zeigt die Modifikation gemäß Fig. 4b.

Fig. 5 zeigt eine Alternative eines Formschlussmechanismus.

Fig. 6 zeigt ein Detail eines Stempels zum Verbinden eines Bauelements mit einem Substrat.

Fig. 7a zeigt eine Ansicht eines Stempels von einer Unterseite des Stempels aus betrachtet, Fig. 7b zeigt eine seitliche Ansicht des Stempels, dessen Schaft in einer Stempelführungsplatte geführt ist, und Fig. 7c zeigt eine Ansicht des in der Stempelführungsplatte geführten Stempelschafts von einer Oberseite aus betrachtet.

Fig. 8 zeigt eine Detailansicht eines Unterteils der Vorrichtung mit einer Einrichtung zur thermischen Trennung.

Fig. 9 zeigt eine Alternative einer Einrichtung zur thermischen Trennung.

Fig. 10 zeigt eine Zylinderplatte gemäß Stand der Technik.

Fig. 11 zeigt eine Vorderansicht der Zylinderplatte der Fig. 10.

Fig. 12 zeigt eine Schnittansicht der Zylinderplatte der Fig. 10 entlang der Linie A-A in der Fig. 11.

Fig. 13 zeigt eine perspektivische Ansicht einer erfindungsgemäßen Zylinderplatte.

Fig. 14 zeigt eine Vorderansicht der Zylinderplatte der Fig. 13.

Fig. 15 zeigt eine Schnittansicht der Zylinderplatte der Fig. 13 entlang der Linie A-A in der Fig. 14.

Fig. 16 zeigt eine perspektivische Ansicht einer weiteren Ausführungsform einer erfindungsgemäßen Zylinderplatte.

Fig. 17 zeigt eine Vorderansicht der Zylinderplatte der Fig. 16.

Fig. 18 zeigt eine Schnittansicht der Zylinderplatte der Fig. 16 entlang der Linie A-A in der Fig. 17.

Fig. 19 zeigt eine weitere Zylinderplatte gemäß Stand der Technik.

Fig. 20 zeigt eine Vorderansicht der Zylinderplatte der Fig. 19.

Figs. 20a, 20b und 20c zeigen Schnittansichten der Zylinderplatte der Fig. 19 entlang der Linien A-A, B-B bzw. C-C der Fig. 19.

Fig. 21 zeigt eine perspektivische Ansicht einer weiteren Ausführungsform einer erfindungsgemäßen Zylinderplatte.

Fig. 22 zeigt eine Vorderansicht der Zylinderplatte der Fig. 21.

Fig. 23 zeigt eine Schnittansicht der Zylinderplatte der Fig. 21 entlang der Linie A-A in der Fig. 22.

Fig. 24 zeigt eine perspektivische Ansicht einer mehrteiligen Zylinderplatte und einer Stempelplatte gemäß einer Ausgestaltung der Erfindung.

Fig. 25 zeigt eine Vorderansicht der Zylinderplatte mit Stempelplatte gemäß Fig. 24.

Fig. 26 zeigt eine Draufsicht auf die Zylinderplatte der Fig. 24

Fig. 27 zeigt eine Draufsicht auf eine Stempelplatte entsprechend der Linie A-A der Fig. 25.

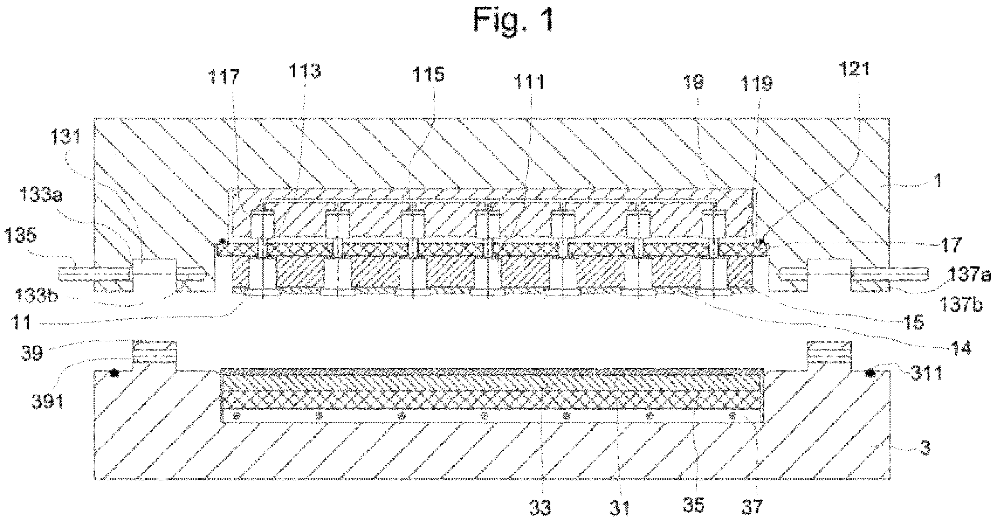

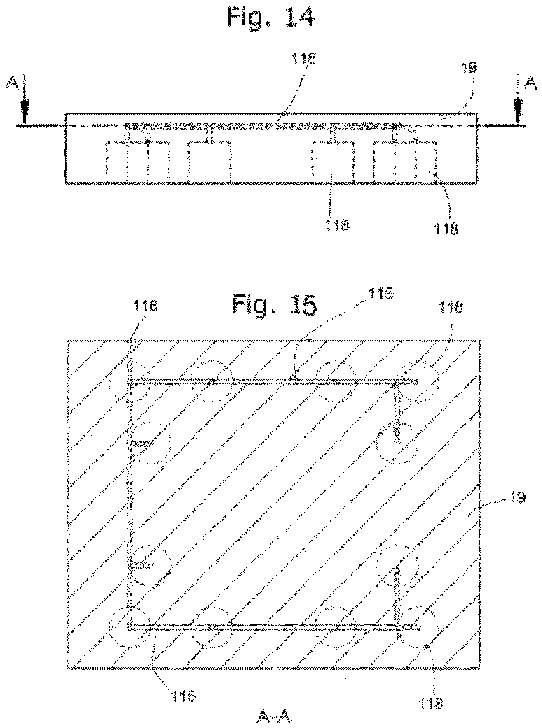

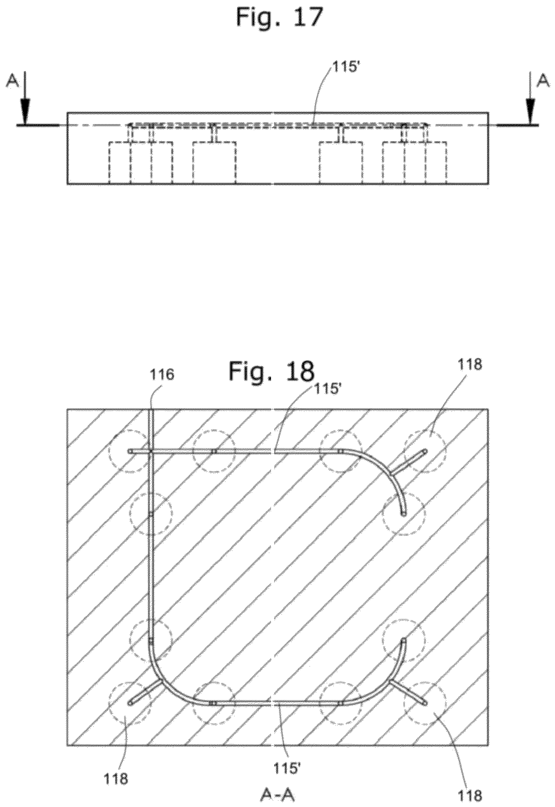

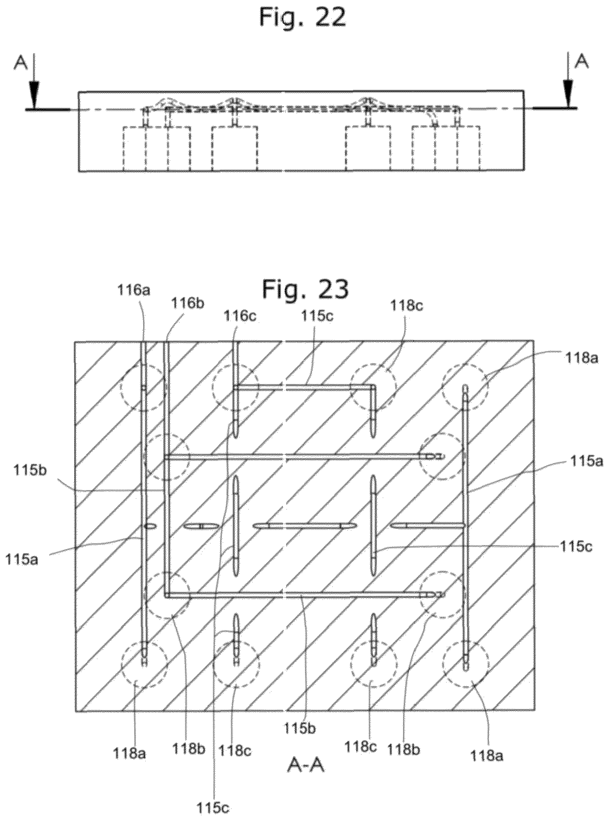

Ausführungsformen der Erfindung werden anhand der Figs. 1 bis 23 beschrieben. Bei den Figuren handelt es sich um schematische Figuren, und es können beschriebene Details weggelassen sein.

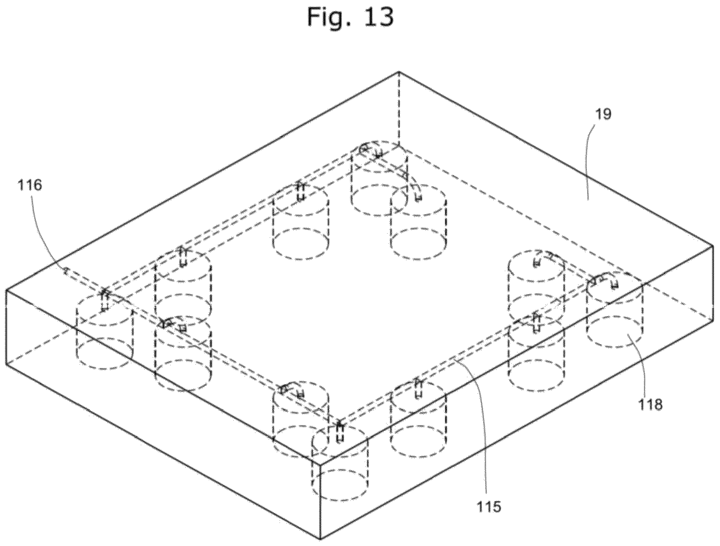

Die Figs. 13 bis 15 zeigen eine erste Ausführungsform einer erfindungsgemäßen Zylinderplatte.

Die Zylinderplatte ist durch additive Fertigung hergestellt. Dazu wird ein flüssiges Material schichtweise auf eine Arbeitsfläche aufgetragen. Nach dem Auftragen verfestigt sich das flüssige Material, sodass weitere Schichten auf die bereits vorhandenen verfestigten Materialschichten aufgetragen werden können. Das Auftragen findet derart statt, dass Bereiche ausgespart bleiben, die in der fertigen Zylinderplatte nicht mit Material versehen sind. Dabei handelt es sich insbesondere um Zylinderbohrungen 118 und eine Druckzufuhrleitung 115. Wie aus den Figs. 13 bis 5 ersichtlich ist, ist die Druckzufuhrleitung 115 von einem Anschluss 116 an der Seite der Zylinderplatte 19 zu den Zylinderbohrungen 118 geführt.

Es sei noch darauf hingewiesen, dass in den Figs. zur besseren Übersichtlichkeit nicht jedes Element mit Bezugszeichen versehen ist. Z.B. ist in der Fig. 13 eine Zylinderbohrung mit dem Bezugszeichen 118 versehen. Die übrigen Zylinderbohrungen sind aber abgesehen von ihrer Position gleichartig wie die mit dem Bezugszeichen versehene Zylinderbohrung.

Da die Druckzufuhrleitung 115 durch frei lassen der durch diese eingenommenen Bereiche gefertigt wird, nimmt sie im Gegensatz zu der Druckzufuhrleitung 191 gemäß Stand der Technik (siehe z.B. Fig. 10) keinen unnötigen Raum ein, an Stellen ein, an denen sie gar nicht benötigt wird. Aus diesem Grund ist nicht nur die Festigkeit der Zylinderplatte 19 verbessert, sondern es entfällt auch das Erfordernis, die durch Bohrung entstandenen Teile der Leitungen, die zu dem Rand der Zylinderplatte 19 ragen, wieder zu verschließen.

Gemäß der Zylinderplatte des Stands der Technik müssen nämlich die Bohrungen wieder verschlossen werden, was allerdings nur bedingt möglich ist. Aus diesem Grund bleiben Teile der Bohrungen vorhanden, obwohl an diesen Stellen eine Druckzufuhrleitung nicht erforderlich ist. Durch diese frei bleibenden Bereiche wie auch durch das zusätzlich eingebrachte Material zum Verschließen der Bohrungen kann es zu negativen Einflüssen auf die Festigkeit der Zylinderplatte gemäß Stand der Technik kommen. Diese Nachteile sind gemäß der Erfindung vermieden.

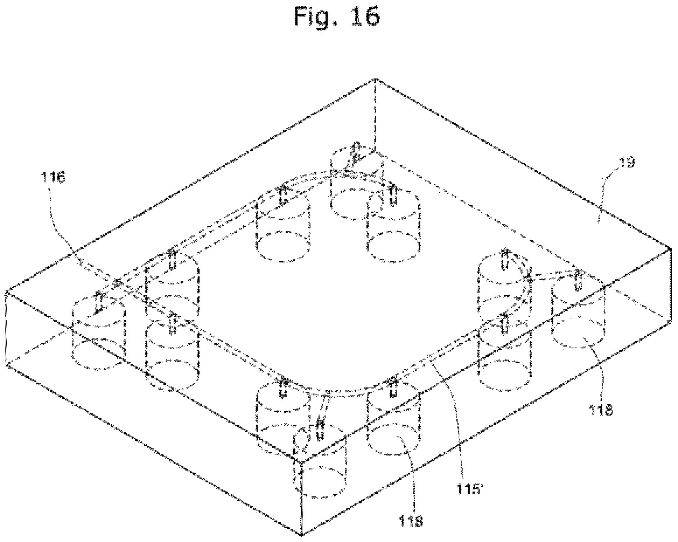

Aus den Figs. 16 bis 18 ist eine weitere Ausführungsform einer Zylinderplatte gemäß der Erfindung ersichtlich. Hier ist eine Druckzufuhrleitung 115' abweichend zu der geradlinigen Gestaltung der ersten Ausführungsform der Figs. 13 bis 15 die Druckzufuhrleitung 115' in einer gekrümmten Weise ausgeführt. Dadurch verringert sich das durch die Druckzufuhrleitung 115' eingenommene Volumen in der Zylinderplatte 19, wodurch die Festigkeit der Zylinderplatte 19 abermals verbessert wird.

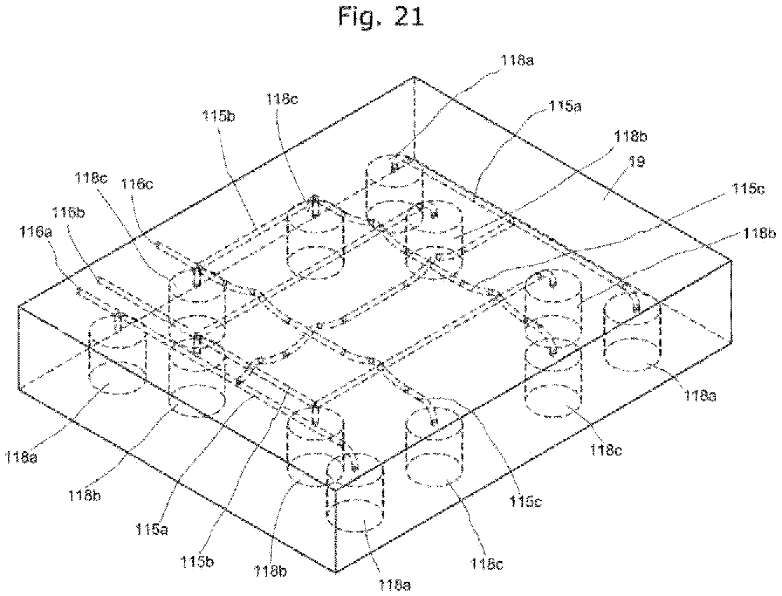

Aus der Fig. 21 und den Figs. 22 und 23 ist eine dritte Ausführungsform der Zylinderplatte 19 gemäß der Erfindung ersichtlich. Hier sind die Zylinderbohrungen in drei Gruppen von Zylinderbohrungen 118a, 118b 118c aufgeteilt. Jede dieser einzelnen Gruppen wird durch eine eigene Druckzufuhrleitung 115a, 115b oder 115c, von Anschlüssen 116a, 116b, 116c mit einem Druckmedium versorgt. Die Druckzufuhrleitungen 115a, 115b und 115c liegen alle in derselben Ebene. Lediglich bei Kreuzungspunkten und Schnittpunkten von zwei Leitungen wie zum Beispiel der Leitung 115a mit der Leitung 115b ist eine der Druckzufuhrleitungen über die andere geführt. Aus der Fig. 21 ist gezeigt, dass z.B. die Druckzufuhrleitung 115a sowohl über die Druckzufuhrleitung 115b wie auch über die Druckzufuhrleitung 115c geführt ist, um die von dem Anschluss entfernten Zylinderbohrungen 118a, 118a in der Figur in der Zeichnung oben und rechts zu versorgen. In ähnlicher Weise ist die Druckzufuhrleitung 115c an Kreuzungen mit der Druckzufuhrleitung 115b über diese geführt.

Neben einer im 3D-Raum beliebig gekrümmten Ausgestaltung der Druckzufuhrleitungen ermöglicht es die additive Fertigung auch, die Druckzufuhrleitungen wesentlich dünner als gemäß dem Stand der Technik herzustellen. Beispielsweise sind Durchmesser von 0,1 mm bis 1 mm möglich. Aufgrund dieser verringerten Druckzufuhrleitungsquerschnitte ist die Mantelfläche der Druckzufuhrleitungen wesentlich kleiner als in dem Stand der Technik. Aus diesem Grund wirkt auf die Struktur der Zylinderplatte selbst eine geringere Druckkraft. Diese ist bekanntermaßen durch

$$F = p * A \qquad (1)$$

ausgedrückt. In der Gleichung steht F für die Kraft, p steht für den Druck und A steht für die Fläche, auf die der Druck wirkt. Hier handelt es sich bei A um die Mantelfläche der Leitung. Demzufolge können geringere Wandstärken ausgeführt werden, wodurch der Materialaufwand für die Zylinderplatte trotz der aufgrund der additiven Fertigung reduzierten Festigkeit geringer als in Zylinderplatten gemäß Stand der Technik ausfallen kann.

Da neben der Mantelfläche der Druckzufuhrleitungen auch das Volumen der Druckzufuhrleitungen im Vergleich zu dem Stand der Technik geringer ist, ist ein Energieaufwand zum Einbringen des bevorzugt gasförmigen Druckmediums in die Druckzufuhrleitungen verringert. Die technische Arbeit zum Erreichen eines bestimmten Drucks hängt nämlich von dem Volumen ab, in dem der Druck zu erreichen ist. Dies wird durch die Gleichung

$$A_{t12} = V(p_2 - p_1) \qquad (2)$$

ausgedrückt. In der obigen Gleichung steht $A_{t12}$ für die technische Arbeit um ausgehend von einem ersten Zustand einen zweiten Zustand zu erreichen, V steht für das Volumen und $p_1$ bzw. $p_2$ stehen für die Drücke in dem ersten bzw. dem zweiten Zustand, d.h. vor und nach dem Einbringen des Drucks.

Da die Druckzufuhrleitungen lediglich in einer Ebene angeordnet sind, und nur beim Kreuzen von Leitungen die Ebene kurz verlassen werden muss, kann die Zylinderplatte gemäß der Erfindung durch additive Fertigung mit einer viel kleineren Dicke ausgeführt werden als dies gemäß Stand der Technik möglich ist.

Dazu kommt noch als weiterer Vorteil, dass es nicht erforderlich ist, die gemäß Stand der Technik von außen gebohrten Druckzufuhrleitungen z.B. durch Stopfen oder durch Schweißen wieder zu verschließen. Das Einschrauben von Stopfen in die Bohrlöcher bedeutet nämlich nicht nur eine aufwändigere Fertigung, da es erforderlich ist, in den Bohrlöchern Gewinde herzustellen, um die Stopfen einzuschrauben, und weitere Fertigungsschritte, sondern auch Ausfall- und Verschleißrisiken. Ein Verschweißen der nach außen offenen Bohrlöcher bedeutet wiederum eine thermische Beanspruchung des Bauteils, das sich durch die thermische Beanspruchung verziehen kann. Außerdem kann die Wärmeeinwirkung beim Schweißen lokal zu Änderungen der Materialeigenschaften führen, wodurch die Festigkeit der Zylinderplatte lokal beeinträchtigt werden kann.

Da es nicht möglich ist, die nach Fertigung der Druckzufuhrleitungen nicht mehr benötigten Bohrlöcher vollständig in ihrer gesamten nicht für die Druckzufuhrleitung benötigten Länge zu verschließen, verbleibt außerdem gemäß Stand der Technik ein unnötiges Leitungsvolumen, das unter unnötigem Energieaufwand mit Druck beaufschlagt werden muss, wie aus der Gleichung (2) oben ersichtlich ist. Außerdem besteht ein Risiko, durch die größere Druckkraft die Struktur der Zylinderplatte zu schädigen.

Im Folgenden wird eine erfindungsgemäße Vorrichtung zum Verbinden eines Bauelements mit einem Substrat beschrieben, die mit einer der vorstehend beschriebenen, additiv gefertigten Zylinderplatten versehen ist.

Die erfindungsgemäße Vorrichtung ist mit Bezug auf die Fig. 1 in Form einer Kammer ausgebildet, die ein Oberteil 1 (erstes Teil) und ein Unterteil 3 (zweites Teil) hat. Die Kammer hat im Wesentlichen die Form eines hohlen Quaders mit vier Seitenwänden, Boden und Deckelwand. Durch Trennen des Unterteils 3 von dem Oberteil 1 kann die Kammer in zwei Teile geöffnet werden, deren Öffnungen zueinander gerichtet sind.

In dem Unterteil 3 ist eine auch als Produkthalter bezeichnete Pressplatte 31 vorgesehen, die eine Funktion eines Gegenstempels übernimmt. Die Pressplatte 31 dient dazu, vor einem Sintervorgang Ausgangsstoffe wie ein Substrat, eine Sinterpaste und ein Bauelement anzuordnen. Unterhalb von der Pressplatte 31 ist eine Heizplatte (Heizeinrichtung) 33 angeordnet. Die Heizplatte 33 dient dazu, während eines Sintervorgangs Wärme an die Pressplatte 31 abzugeben und diese dabei aufzuwärmen.

Das Oberteil wird anhand der der Figs. 1, 6 und 7 genauer beschrieben. An dem Oberteil 1 der Kammer ist an einer obersten Position, d.h. eine Position die am weitesten von der Öffnung des Oberteils 1 entfernt liegt, eine Zylinderplatte 19 vorgesehen. Die Zylinderplatte 19 ist additiv gefertigt und weist Zylinderbohrungen 118, 118a, 118b, 118c auf, in denen Kolben 117 aufgenommen sind. Die Zylinderbohrungen 118, 118a, 118b, 118c an einer von dem jeweiligen Kolben 117 abgewandten Seite der Zylinderplatte 19 sind mit einer Druckzufuhrleitung 115, 115', 115a, 115b, 115c in Verbindung. Diese Kolben-Zylinderanordnung dient als eine pneumatische Verstellungseinrichtung. Beispiele für unterschiedliche Anordnungen einer oder mehrerer Druckzufuhrleitungen sind aus den Figs. 13 bis 18 und 21 bis 23 ersichtlich und im Zusammenhang mit der erfindungsgemäßen Zylinderplatte 19 weiter oben beschrieben.

Zur Betätigung der Kolben 117 wird über die Druckzufuhrleitung 115, 115', 115a, 115b, 115c ein mit Druck beaufschlagtes Fluid wie z.B. Luft in die Zylinderbohrungen 118, 118a, 118b, 118c in der Zylinderplatte 19 eingebracht, wodurch die Kolben 117 betätigt werden. Durch die Betätigung bewegen sich die Kolben 117 zusammen mit einer an einer zu dem Unterteil 3 gerichteten Seite des Kolbens 117 vorgesehenen Führungsstange 113 in Richtung des Unterteils 3 der Kammer. Diese Richtung wird im Folgenden auch als "Richtung nach unten" oder einfach "nach unten" bezeichnet und entspricht in den Figuren einer Richtung von der Blattoberseite zu der Blattunterseite.

Während es bevorzugt ist, alle Kolben gleichzeitig durch Beaufschlagen des Fluids in der Druckzufuhrleitung mit einem vorgegebenen Druck zu betätigen, ist es alternativ möglich, Mittel vorzusehen, um die Kolben 117 einzeln anzusteuern. Eine Rückstellung der Kolben 117 erfolgt durch Anlegen eines Unterdrucks in der Druckzufuhrleitung 115, 115', 115a, 115b, 115c, wodurch die Kolben 117 mit den Führungsstangen 113 in ihre Ausgangsposition zurückgeführt werden.

Jeder Kolben 117 kann über die Führungsstange 113 mit einem Schaft 111 eines Stempels in Anlage gebracht werden. Dies erfolgt, indem ein abgerundetes, von dem Kolben 117 abgewandtes Ende der Führungsstange 113 durch die Betätigung des Kolbens 117 nach unten gegen eine zu dem Kolben 117 gerichtete, eben ausgebildete Stirnfläche des Schafts 111 geführt wird.

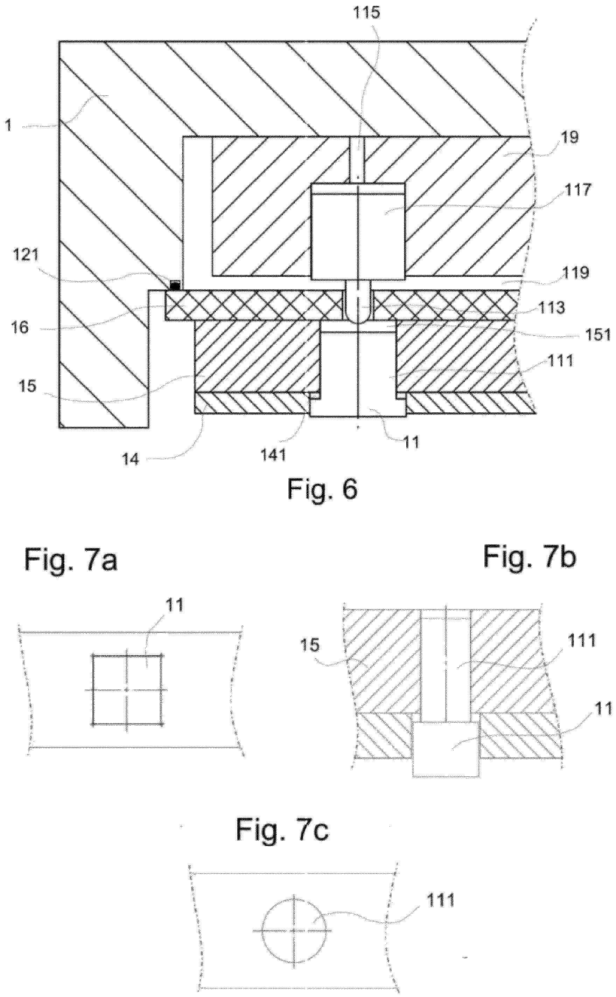

Wie insbesondere aus der Fig. 6 ersichtlich ist, ist die Führungsstange 113 dabei durch ein Loch in einer oberhalb einer Stempelführungsplatte 15 angeordneten Oberplatte 16 geführt. Die Oberplatte 16 ist außerdem mit den Innenwänden des Oberteils 1 derart in Anlage, dass ein zwischen der Oberplatte 16 und der Zylinderplatte 19 vorhandener Raum unabhängig von dem Druck in der Druckzufuhrleitung 115, 115', 115a, 115b, 115c mit einem Überdruck oder Unterdruck beaufschlagt werden kann. Bevorzugt ist dazu zwischen den Innenwänden des Oberteils 1 und der Oberplatte 16 eine Dichtung 8 vorgesehen. Der Raum zwischen der Oberplatte 16 und der Zylinderplatte 19 ist als Zwischensteuerraum 119 bezeichnet.

Der Schaft 111 des Stempels ist zylindrisch ausgebildet und durch ein Loch in einer Stempelführungsplatte 15 geführt. Der Durchmesser des Lochs ist dabei so bemessen, dass er den Durchmesser des Schafts 111 des Stempels geringfügig überschreitet, d.h. es liegt hier eine Spielpassung mit Übermaß vor. Das Spaltmaß beträgt zwischen 8 und 12 $\mu$m. Ein Spaltmaß von 10 $\mu$m ist dabei bevorzugt.

An der von dem von dem Kolben abgewandten Seite des Schafts 111 befindet sich ein Druckkörper 11 des Stempels, der zu der Pressplatte 31 gerichtet ist. In der Fig. 1 sind sieben Stempel dargestellt, allerdings ist die Zahl der Stempel in keinster Weise beschränkt, sondern kann beliebig gewählt sein. Insbesondere kann auch nur ein einziger Stempel vorgesehen sein, obwohl eine größere Anzahl an Stempeln bevorzugt ist.

Jeder Stempel ist aus einem Teil gefertigt und besteht aus dem Schaft 111 und dem Druckkörper 11. Der zylindrische Schaft 111 ist durch die Stempelführungsplatte 15 geführt und kann aufgrund der Spielpassung mit Übermaß zu einem geringen Ausmaß gekippt werden. Hier kann das maximal mögliche Ausmaß des Kippens durch das genaue Spaltmaß zwischen Schaft 111 und dem Loch durch die Stempelführungsplatte 15 eingestellt werden.

Das Kippen wird dadurch ermöglicht, dass die Führungsstange 113 ein abgerundetes Ende aufweist, das auf der zu dem Kolben 117 gerichteten planen Stirnfläche des Schafts 111 abrollen kann. Dadurch, dass der Schaft 111 und damit der Stempel 11 kippen können, ist es möglich, eine Schräglage der zu sinternden Bauelemente auszugleichen. Das heißt, dass der Stempel bei Heranführen an ein nicht exakt eben ausgerichtetes Bauelement in der Lage ist, sich durch Kippen an die Schräge des Bauelements anzupassen.

Der Druckkörper 11 des Stempels ist quaderförmig ausgebildet. Seine Fläche an der von dem Kolben abgewandten Unterseite wird als Druckfläche bezeichnet. Die Abmessungen der Druckfläche übersteigen geringfügig die des zu sinternden Produkts, um bei kleinen Lageabweichungen wie z.B. einer geringfügigen Verdrehung des Stempels und damit des Druckkörpers 11 das zu sinternde Bauteil dennoch zuverlässig vollständig abzudecken.

Der Druckkörper 11 des Stempels ist in einer Ausnehmung 141 aufgenommen, die an einer Unterseite einer unterhalb der Stempelführungsplatte 15 vorgesehenen Stempelunterplatte 14, vorgesehen ist. Die Dicke der Stempelunterplatte 14 und damit der Ausnehmung 141 ist so bemessen, dass es dem Druckkörper 11 des Stempels während einer Druckbeaufschlagung durch die Kolben 117 nicht möglich ist, vollständig aus der Ausnehmung herauszugeraten. Die Gesamthöhe der Ausgangsstoffe und damit der erforderliche Verfahrweg des Stempels bewegen sich nämlich im Mikrometerbereich, während die Höhe des Druckkörpers und auch der Ausnehmung einige Millimeter beträgt.

Ein Abstand zwischen den Seiten des Druckkörpers 11 und den Innenwänden der Ausnehmung 141 ist dabei größer bemessen als der Abstand zwischen dem Schaft 111 und der Innenwand des Lochs. Aus diesem Grund ist ausgeschlossen, dass es durch das voranstehend beschriebene, mögliche Kippen des Stempels zu einem Verklemmen des Druckkörpers 11 in der Ausnehmung 141 kommt.

Da der Stempel mit der Führungsstange 113 bzw. dem Kolben 117 lediglich in Anlage gerät, aber nicht fest damit verbunden ist, verbleibt der Stempel nach einer Druckbeaufschlagung in einer ausgefahrenen Position, obwohl der Kolben 117 und die Führungsstange 113 durch Beaufschlagen der Druckzufuhrleitung mit einem Unterdruck wieder in ihre Ausgangsposition zurückgeführt werden. Dieser Zustand ist schematisch in der Fig. 6 gezeigt.

Um den Stempel von dem gesinterten Produkt zu lösen und in seine Ausgangsposition zurückzuführen, wird der Zwischensteuerraum 119 mit einem Unterdruck beaufschlagt und der Stempel aufgrund des nun vorherrschenden Druckunterschieds zwischen dem Bereich des Druckkörpers 11 und dem Zwischensteuerraum zurück in seine Ausgangsposition gesaugt. Dabei entsteht allerdings eine geringe Luftströmung zwischen dem Schaft 111 und der Innenwand des Lochs sowie zwischen den Wänden des Druckkörpers 11 und den Innenwänden der Ausnehmung 141.

Diese geringe Luftströmung ist allerdings vernachlässigbar klein und wird beendet, sobald die den Schaft 111 umgebende obere Fläche des Druckkörpers 11 gegen die Stempelführungsplatte 15 gerät. Da der Druckkörper 11 des Stempels mit seiner oberen Fläche in Anlage gegen die Unterseite der Stempelführungsplatte 15 gerät, ist verhindert, dass die Stirnfläche des Schafts 111 gegen die Führungsstange 113 des zurückgezogenen Kolbens 117 stößt. Dies hat den Vorteil, dass es zu einer thermischen Trennung zwischen dem nach dem Sinterprozess heißen Stempel und dem Kolben kommt.

Einen Beitrag zur Rückstellung des Stempels liefert dabei auch ein aus einem Zwischenraum 151 zwischen der Stirnseite des Schafts 111 und der Oberplatte 16 gesaugte Luft, wie aus Fig. 6 ersichtlich ist. In dem Zwischenraum 151 vorhandene Luft wird nämlich bereits einerseits durch das Rückstellen der Führungsstange 113 durch das Herstellen des Unterdrucks in der Zwischensteuerkammer 119 verstärkt wird.

Aufgrund dieser Ausgestaltung ist es möglich, einen defekten Stempel jederzeit ohne großen Aufwand auszutauschen oder abhängig vom zu sinternden Bauteil einen vollständigen Austausch aller Stempel vorzunehmen. Hierzu ist es lediglich erforderlich, die Stempel und die Stempelunterplatte 14 mit den Ausnehmungen 141 aus der Kammer zu entnehmen und gegen andere Stempel mit einer Stempelunterplatte mit passenden Ausnehmungen auszutauschen.

Sollte es trotz der thermischen Trennung zu einem Verklemmen des Kolbens 117 kommen und dieser lediglich aufgrund des Unterdrucks in der Druckzufuhrleitung 115, 115', 115a, 115b, 115c nicht zurückgezogen werden können, kann durch eine Druckerhöhung in dem Zwischensteuerraum 119 ein Druck auf die Unterseite des Kolbens ausgeübt werden, wodurch sich die Verklemmung lösen und der Kolben 117 in die Ausgangsposition zurückfahren kann.

Hier sei noch erwähnt, dass aufgrund von unterschiedlichen Querschnitten des Kolbens 117 und des Stempels mit der Druckfläche des Druckkörpers 11 ein Mindestverhältnis von durch den Kolben 117 auf die Führungsstange 113 und den Schaft 111 ausgeübten Eingangsdruck zu dem Ausgangsdruck der Stempelfläche einzuhalten ist. Der Eingangsdruck wird auf einen kreisförmigen Querschnitt des Kolbens 117 aufgebracht.

Bei einer möglichen Ausbildung des Stempels mit der Druckfläche in einer quadratischen Form sei die Seitenlänge des Quadrats "a". Der Kolben 117 weist in beiden Fällen einen kreisförmigen Querschnitt mit einem Radius "a" auf. In diesem Fall, in dem der Querschnitt der Stempelfläche quadratisch ist, ist das Verhältnis von Eingangs- zu Ausgangsfläche am kleinsten. D.h., der auf das Bauelement ausgeübte Druck wird maximal, wie sich aus der Gleichung

$$P = F / A$$

ergibt. In der Gleichung steht "P" für den Druck, "F" für die Kraft und "A" für die die Querschnittsfläche.

Bei einer Seitenlänge des Quadrats "a" beträgt das Verhältnis von Druckfläche zu Kolbenfläche ca. 1,273. Dies entspricht dem Verhältnis der Fläche eines Quadrats mit der Seitenlänge "a" zu der eines in das Quadrat eingeschriebenen Kreises mit dem Durchmesser "a".

Somit ist es erforderlich, den Kolben 117 mit einem Druck zu beaufschlagen, der höher als der auf die Ausgangsstoffe ausgeübte Druck ist. In dem obigen Beispiel müsste der Eingangsdruck ca. 51 MPa betragen, damit ein gewünschter Abgabedruck von 40 MPa vorherrscht.

In dem Fall einer nicht quadratischen, sondern z.B. rechteckigen Druckfläche ist das Verhältnis analog zu ermitteln. Erforderliche Eingangsdrücke für unterschiedliche Stempelflächen können z.B. in Form einer Tabelle oder für unterschiedliche Abgabedrücke in Form eines Kennfelds bereitgestellt sein.

Details des Unterteils 3 werden insbesondere anhand der Figs. 1, 8 und 9 genauer beschrieben.

An dem Unterteil 3 der Kammer sind in einer Reihenfolge von unten nach oben eine Kühlplatte 37, eine thermische Isolierung in Form einer Isolierplatte 35, eine Heizplatte 33 und ein Produkthalter 31 vorgesehen. Der Produkthalter 31 dient als Gegenstempel und dient dazu, ein Substrat zu tragen, auf welches Bauelemente zu sintern sind.

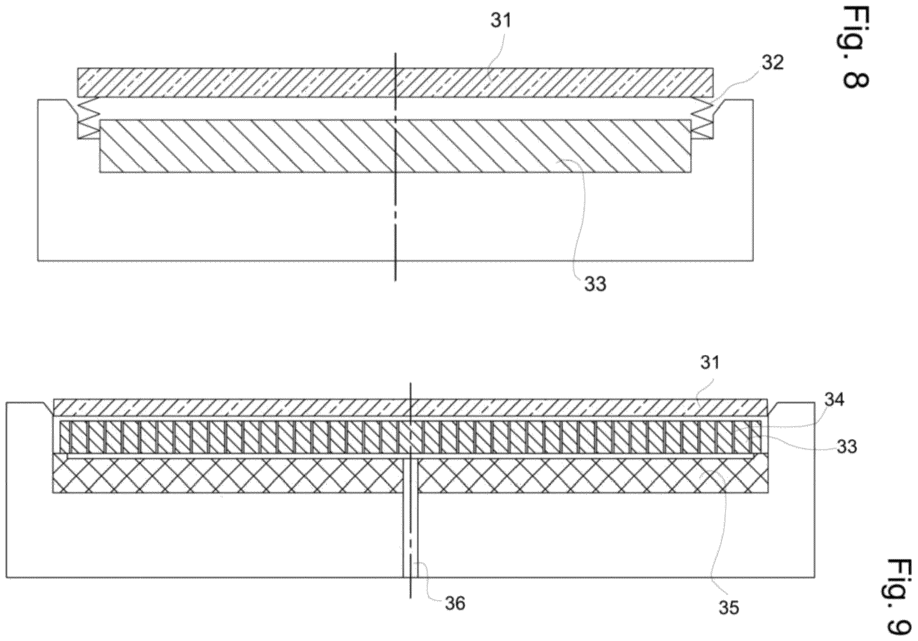

Um die Qualität des gesinterten Erzeugnisses zu verbessern, ist es erforderlich, eine Wärmezufuhr zu den Ausgangsstoffen möglichst zeitglich mit der Druckausübung durch den Stempel vorzunehmen. Hierzu ist eine thermische Trennung zwischen der Heizplatte 33 und dem darüber vorgesehenen Produkthalter 31 vorgesehen, wie aus der Fig. 8 schematisch ersichtlich ist.

Um die thermische Trennung herbeizuführen, sind zwischen einer Unterseite des Produkthalters 31 und einer Bodenwand des Unterteils 3 Vorspannelemente 32 vorgesehen, die den Produkthalter 31 von der Heizplatte 33 beabstandet nach oben vorspannen. Die Vorspannelemente 32 können in Form von Federn wie z.B. Spiralfedern ausgeführt sein, wie in der Fig. 8 schematisch dargestellt ist, sind aber nicht darauf beschränkt.

Beispielsweise sind anstelle der schematisch angedeuteten Spiralfedern andere Arten von Federn wie Blattfedern, Hydraulik- oder Pneumatikkolben oder mechanische Mittel wie Zahnstangen als Vorspannelemente möglich.

Aufgrund der Vorspannelemente 32 befindet sich der Produkthalter 31 in einer von der Heizplatte 33 beabstandeten Position, in der eine Wärmeübertragung höchstens in reduzierter Weise stattfindet, da sich ein Luftspalt als Isolator zwischen dem Produkthalter 31 und der Heizplatte 33 befindet. Sobald die Stempel betätigt werden und beginnen, einen Druck auf die Ausgangsstoffe und den diese tragenden Produkthalter auszuüben, wird die Vorspannkraft der Vorspannelemente 32 überwunden und der Produkthalter 31 in Anlage mit der Heizplatte 33 gebracht. In diesem Zustand kommt es zu einer direkten Wärmeübertragung von der Heizplatte 33 zu dem Produkthalter 31 und weiter auf die Ausgangsstoffe.

Somit sind die Ausgangsstoffe zeitgleich dem Druck und der Wärme ausgesetzt, bis die Druckbelastung durch den Stempel durch Zurückstellen des Kolbens 117 beendet wird. Zeitgleich mit dem Beenden der Druckbelastung, wird wiederum durch die Vorspannkraft der Vorspannelemente 32 der Produkthalter 31 von der Heizplatte 33 entfernt, sodass ein weiteres Erwärmen des Produkthalters 31 und der Ausgangsstoffe durch die noch immer heiße Heizplatte 33 unterbleibt.

Es sei darauf hingewiesen, dass die Darstellung der Fig. 8 lediglich die für die thermische Trennung wichtigen Bauteile zeigt, der Gesamtaufbau aber so ausgeführt sein kann, wie in der Fig. 1 dargestellt ist. Z.B. kann zwischen der Heizplatte 33 und der Bodenwand des Unterteils 3 eine thermische Isolierung, eine Kühlung usw. vorhanden sei.

Die Fig. 9 zeigt in schematischer Weise eine Alternative zur thermischen Trennung von Produkthalter und Heizplatte. Gemäß der Alternative ist die Heizplatte mit einer Vielzahl von ihrer Unterseite zu ihrer Oberseite gerichteten Durchgangslöchern (Luftkanälen) versehen, die mit einem durch die Bodenwand des Unterteils 3 und die thermische Isolierung 35 der Heizplatte 33 führenden Luftzufuhrkanal 36 in Verbindung sind. Um den Produkthalter 31 thermisch von der Heizplatte 33 zu trennen, wird bis zur Aktivierung des Drucks durch den Kolben 117 auf den Stempel Luft oder ein anderes geeignetes Fluid durch den Luftzufuhrkanal 36 zugeführt. Nachdem diese Luft durch die vielen Luftkanäle in der Heizplatte 33 durchgegangen ist, bildet sie zwischen der Heizplatte 33 und dem Produkthalter ein Luftkissen, das neben einer thermischen Trennung für eine zusätzliche Isolierung gegen Strahlungswärme sorgt.

Durch Unterbrechen der Luftzufuhr zum Zeitpunkt der Druckbetätigung des Kolbens 117 wird das Luftkissen zwischen der Heizplatte 33 und dem Produkthalter 31 beseitigt. Der Produkthalter 31 gerät gegen die Heizplatte in Anlage und erfährt somit eine sofortige Erwärmung. Diese Wärme wird zeitgleich auf die dann unter Druck durch den Stempel stehenden Ausgangsstoffe übertragen.

Zur Durchführung des Sinterprozesses wird die Vorrichtung geschlossen, indem das Oberteil 1 und das Unterteil 3 zusammengeführt werden. Dieser Vorgang wird insbesondere anhand der Figs. 1 bis 5 beschrieben.

Die Seitenwände des Oberteils 1 weisen an ihrem zu dem Unterteil 3 gerichteten Rand eine Ausnehmung 131 auf. Neben der Ausnehmung 131 befinden sich entsprechende Vorsprünge 137a und 137b. Die Seitenwände des Unterteils 3 weisen einen entsprechenden Vorsprung 39 auf, der zwischen den Vorsprüngen 137a und 137b in die Ausnehmung 131 eingeführt wird, wenn der Rand des Oberteils 1 mit dem Rand des Unterteils 3 in Anlage gebracht wird. Zusätzlich ist außerhalb des Vorsprungs 39 des Unterteils 3 eine Dichtung angeordnet, die mit dem Schließen der Kammer deren Innenraum fluiddicht gegenüber der äußeren Umgebung abdichtet.

In jedem der Vorsprünge 137a, 137b, 39 sind quer zu einer Öffnungs- bzw. Schließrichtung der Kammer Löcher 133a, 133b und 391 vorgesehen, deren Querschnitte in dem in Anlage befindlichen Zustand, d.h. bei geschlossener Kammer, einander überlappen. Die Löcher 133a, 133b und 391 sind in Form von Langlöchern ausgeführt. Dies bedeutet, dass eine Länge $l_1$ der Löcher 133a, 133b des Oberteils und eine Länge $l_2$ des Lochs 391 in dem Unterteil 3 eine Breite b der Löcher 133a, 133b und 391 übersteigt. Bei dem innerhalb liegenden Loch 133b handelt es sich um ein Sackloch.

In den Figuren sind die Proportionen der Löcher in übertriebener Weise dargestellt. Tatsächlich ist es ausreichend, wenn die Längen $l_1$ und $l_2$ die Breiten b der der Löcher 133a, 133b und 391 um ca. 0,5 mm übersteigen.

Die Löcher können beispielsweise in Abhängigkeit ihrer Anzahl einen Durchmesser von 5 bis 40 mm aufweisen. Derselbe Durchmesserbereich trifft für den Stift, bzw. die Stifte zu. Dabei sind Toleranzen von H7 bis 2mm möglich. Wenn die Löcher größer als die Stifte gewählt werden, ergibt sich über den oberen Druckpunkt (d.h., wo der Stift mit der Wand des Lochs in Berührung gerät) in vorteilhafter Weise eine automatische Zentrierung, wodurch hochpräzise Passungen gar nicht erforderlich sind.

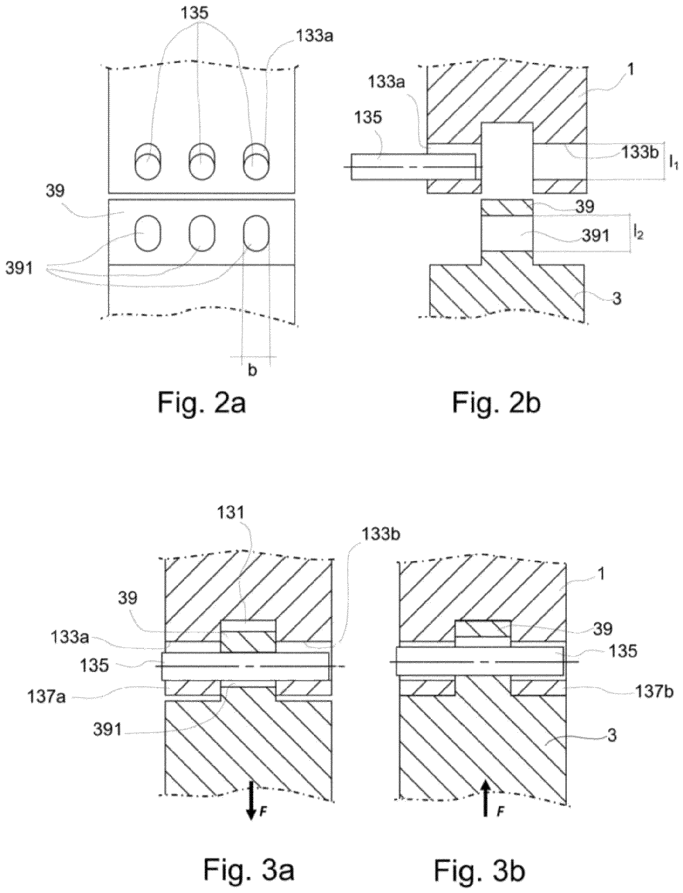

Wegen der Proportionen der Löcher 133a, 133b und 391, kann ein zylindrischer Stift 135 in dem in Anlage befindlichen Zustand aufgrund des durch die Langlochform geschaffenen Spiels einfach durch alle Löcher geführt werden. Sobald der Kolben 117 eine Druckbelastung auf den Stempel und über diesen auf das Unterteil 3 der Kammer ausübt, stellt sich eine Situation gemäß der in Fig. 3a dargestellten ein.

Aufgrund der Druckbelastung wirkt eine Kraft F nach unten, wodurch sich das Unterteil 3 der Kammer aus dem in Anlage befindlichen Zustand so weit nach unten verschiebt, bis eine weitere Verschiebung aufgrund des nun blockierenden Stifts 135 nicht mehr möglich ist. Somit ist es durch diesen Formschluss möglich, die auf das Unterteil wirkende Kraft aufzunehmen, ohne dass aufwändige Hydrauliktische etc. vorgesehen werden müssen.

Wie aus der Fig. 2a ersichtlich ist, sind mehrere Serien der Löcher 133a, 133b und 391 vorgesehen, auf die die entstehende Kraft F aufgeteilt wird. Somit können Anforderungen hinsichtlich der Materialkennwerte der Stifte

Nach dem Verriegeln der Kammer wird der Stempel betätigt, deren Druck auf die Ausgangsstoffe wirkt. Daher entsteht auf die auf dem Produkthalter 31 abgelegten Ausgangsstoffe, wie zum Beispiel ein Substrat, eine Schicht einer Silberpaste als Verbindungsmittel und ein Chip als Bauelement, ein vorbestimmter Druck auf die Ausgangsstoffe. Erfindungsgemäß kann ein Druck von 40 bis 50 MPa erreicht werden.

In der Kammer kann in dem Bereich zwischen dem Produkthalter 31 und der Stempelunterplatte 14 eine Temperatur zwischen 20 °C und 330 °C erreicht werden. Dadurch ist es möglich, einen Verbindungsvorgang zwischen 70 und 120 Sekunden abzuschließen. Vorteilhaft ist hier, dass die Heizplatte so angeordnet ist, dass die Wärme direkt zu dem Produkthalter 31 abgegeben wird.

Die Herstellung des erforderlichen Drucks erfolgt durch Beaufschlagen von Kolben 117 in Zylindern der Zylinderplatte 19 mit einem unter hohem Druck stehenden Gas.

Falls erforderlich kann außerdem in der Kammer durch Einleiten von Gas bzw. Entnehmen davon ein Überdruck oder Unterdruck hergestellt werden und/oder ein Gas wie zum Beispiel Stickstoff zur Förderung des Verbindungsvorgangs oder ein Reaktionsgas zugeführt werden.

Bei Halten dieses Zustands für eine vorgegebene Zeit kommt es zu einem Sintervorgang, d.h. einer Verbindung der Silbermoleküle mit dem Bauelement und dem Substrat.

Sobald die Druckbelastung auf den Stempel endet, kann das Unterteil 3 wieder gegen das Oberteil 1 in Anlage geraten, wie aus der Fig. 3b ersichtlich ist. In diesem Zustand kann der Stift 135 wieder einfach aus den Löchern 133a, 133b und 391 entnommen und die Kammer geöffnet werden, um die fertig gesinterten Bauelemente zu entnehmen.

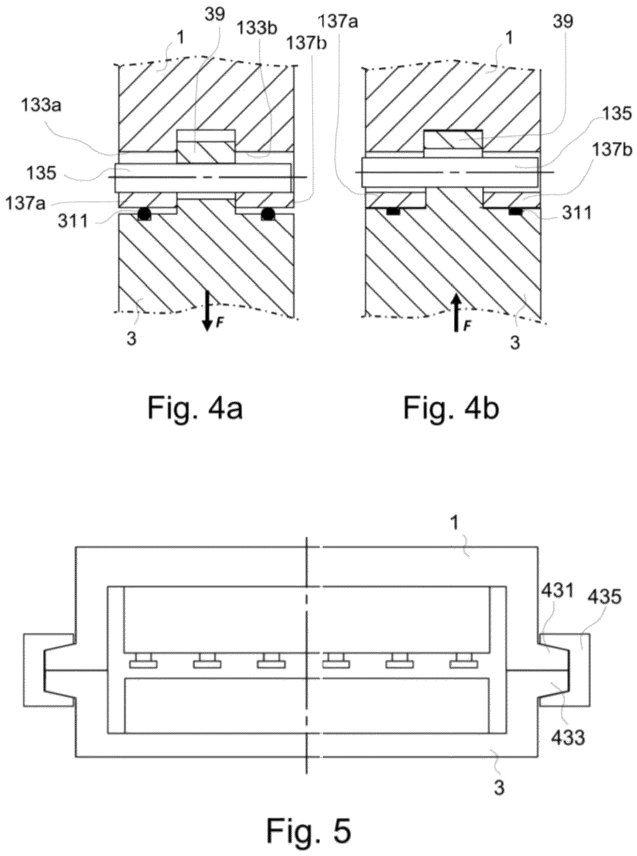

In den Figs. 4a und 4b ist eine Variante gezeigt, in der zusätzlich Dichtungen 311 innerhalb und außerhalb des Vorsprungs 39 vorgesehen sind. Diese Dichtungen 311 sind in der Lage, das Innere der Kammer nicht nur in dem in Anlage befindlichen Zustand (sh. Fig. 4b) sondern auch in dem Druckbelastungszustand (siehe Fig. 4a) fluiddicht abzudichten.

Sämtliche während des Sintervorgangs entstehende Druckkräfte werden aufgrund des Formschlusses durch die Kammer selbst aufgenommen. Daher ist es nicht erforderlich, weitergehende strukturelle Maßnahmen zur Aufnahme oder Ableitung von hohen Druckkräften zu ergreifen.

Eine Alternative zur Ausgestaltung des Formschlusses ist schematisch aus der Fig. 5 ersichtlich. Hier ist anstelle der oben beschriebenen Ausgestaltung jede Seitenwand des Oberteils 1 und des Unterteils 3 mit einem flanschartigen Vorsprung 431, 433 versehen. Die Vorsprünge 431, 433 weisen an ihren voneinander weg gerichteten Flächen eine Schräge auf. Zur Herstellung des Formschlusses wird eine C-förmige Klammer 435 über die Vorsprünge geführt. Die Klammer 435 weist an ihren zu den schrägen Flächen der Vorsprünge gerichteten Schenkelinnenflächen eine korrespondierende Schräge auf, sodass eine flächige Berührung zwischen den Schenkelinnenflächen der Klammer 435 und den schrägen Flächen der Vorsprünge 431, 433 möglich ist. Im Fall der hier beschriebenen Alternative werden die Druckkräfte von der C-förmigen Klammer 435 aufgenommen, die nach Beendigung des Sintervorgangs aufgrund der Schrägen wieder einfach entfernt werden kann.

Anstatt des oben beschrieben zylindrischen Stifts, kann der Formschluss z.B. auch mit Kegelstiften und entsprechend kegelförmigen Bohrungen realisiert werden.

Vorteilhaft kann dieser oben beschriebene Prozess automatisiert erfolgen.

Gemäß Stand der Technik müssen die aufgrund des Pressvorgangs erforderlichen Gegenkräfte mittels externer Strukturen aufgebracht werden. Dort sorgt ein Mechanismus, mit dem eine Trägerbaugruppe zum Halten des Substrats nach oben bewegt wird, für eine externe Kraft, die erforderlich ist, um das Substrat in seiner Position zu arretieren und die für den Prozess erforderliche Gegenkraft zu erzeugen. Dies führt jedoch zu einer Maschinenstruktur, die schwer und sehr komplex ist.

Aufgrund des erfindungsgemäßen Formschlusses schafft die vorliegende Erfindung einen internen Gegenkraftmechanismus. Daher ist eine externe Kraftquelle zur Bereitstellung der Gegenkraft nicht erforderlich.

Zur Vorbereitung des Verbindungsverfahrens wird die Paste auf das Substrat gedruckt und die Bauelemente (Chips) werden auf der Paste angeordnet, d.h. das Substrat wird mit den Chips auf der Paste bestückt. Danach wird das bedruckte und mit Chips bestückte Substrat in die Kammer eingebracht.

Da das Werkzeug anpassbar ist, entsprechen die Positionen des Stempels nämlich den entsprechenden Positionen der Chips auf dem Substrat. Vorteilhaft kann eine Folie z.B. über an den Seiten des Werkzeugs angebrachte Walzen über die Chips platziert werden. Die Folie kann nach jedem Verbindungsvorgang erneuert werden. Dies kann durch Erneuern der Walzen mit der Folie oder durch verändern der Position der vorhandenen Folie vorgenommen werden. Letzteres kann durch Weiterziehen der auf einer Walze aufgewickelten Folie vorgenommen werden, und dabei die Position der Folie geändert werden. Als Folienwerkstoff kann z.B. PTFE oder ein ähnlicher Kunststoff zum Einsatz kommen, ist aber nicht darauf beschränkt.

Der Verbindungsvorgang läuft über einen vorbestimmten Zeitraum bei einer vorbestimmten Temperatur und einem vorbestimmten Druck ab, um das Bauelement wirkungsvoll auf das Substrat zu sintern. Vorteilhaft können vor und nach dem Verbindungsvorgang das Bauelement und/oder die anderen Ausgangsstoffe wie Substrat und Silberpaste durch eine Vorheiz- bzw. Kühlvorrichtung vorgewärmt oder abgekühlt werden.

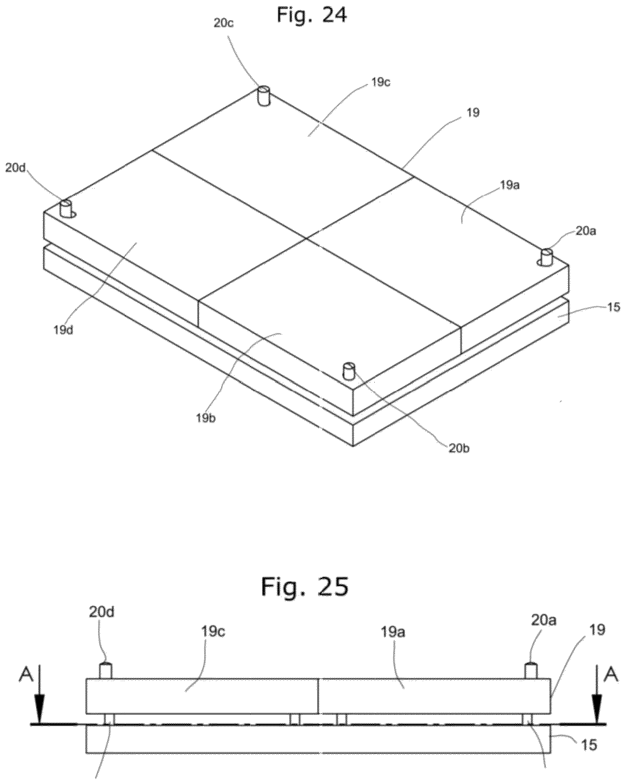

Figs. 24 bis 27 zeigen eine vorteilhafte Ausgestaltung der Zylinderplatte 19. Die Zylinderplatte 19 ist mehrteilig aus vier Teilen 19a, 19b, 19c und 19d ausgeführt. Jedes Teil 19a, 19b, 19c, 19d weist eine Form eines Rechtecks auf. Alle vier Teile 19a, 19b, 19c, 19d sind so angeordnet, dass sie in einem Stoßpunkt A aneinander anliegen. Der Stoßpunkt A entspricht dabei dem Mittelpunkt der Zylinderplatte 19 und auch einem Nullpunkt.

Zur Verbindung mit einem Oberteil einer Vorrichtung zum Verbinden eines Bauelements mit einem Substrat sind Stifte 20a, 20b, 20c, 20d vorgesehen, die in an den Ecken der Zylinderplatte 19 vorgesehenen Löchern 195a, 195b, 195c, 195d aufgenommen sind. Die Löcher 195a, 195b, 195c, 195d sind als Langlöcher ausgeführt, deren Längsachse auf einer Linie liegt, die die jeweilige Ecke der Zylinderplatte 19 bzw. des jeweiligen Teils 19a, 19b, 19c, 19d mit dem Stoßpunkt A verbindet. Somit schneiden sich die Längsachsen der Langlöcher in dem Stoßpunkt A, der in diesem Ausführungsbeispiel auch dem Nullpunkt entspricht.

Diese Anordnung bewirkt, dass im Fall einer Erwärmung der Zylinderplatte 19, der Nullpunkt (Stoßpunkt A) an Ort und Stelle verbleibt, während die äußeren Ecken der Zylinderplatte 19 oder jedes Teils 19a, 19b, 19c, 19d entlang der Achse des entsprechenden Langlochs 195a, 195b, 195c, 195d mit dem jeweiligen Stift 20a, 20b, als Führung aufgrund einer Wärmedehnung verschoben werden können.

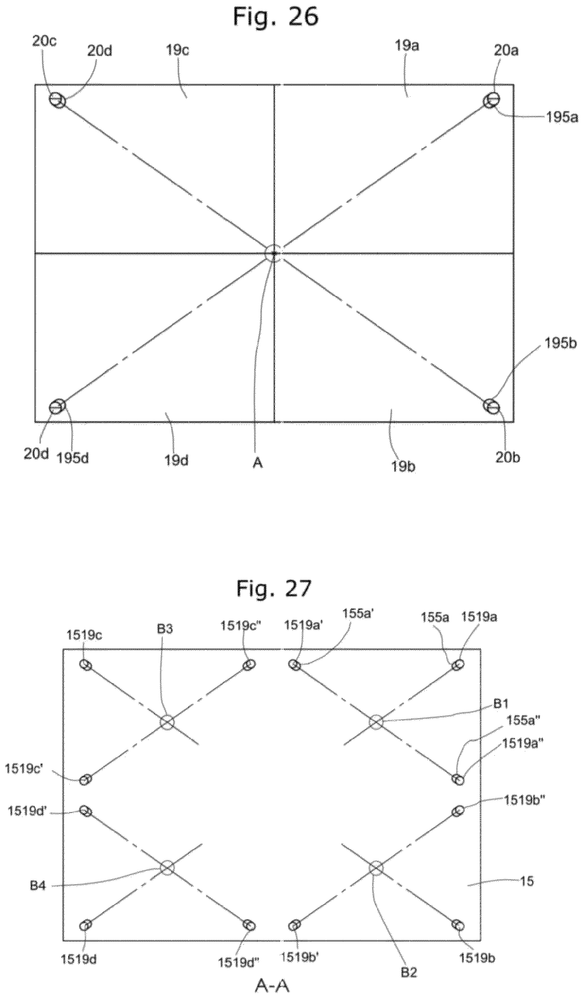

Zur Kompensation einer Wärmedehnung der Stempelführungsplatte 15 ist diese ebenfalls mit Langlöchern 155a, 155a' und 155a'' versehen, wie aus der Fig. 27 ersichtlich ist, und über Stifte 1519a, 1519a', 1519a'',

1519b, 1519b', 1519b", 1519c, 1519c', 1519c", 1519d, 1519d', 1519d" mit den vier Teilen 19a, 19b, 19c, 19d der Zylinderplatte 19 verbunden. Somit ist jedes Teil 19a, 19b, 19c, 19d an drei seiner Ecken mit der Stempelführungsplatte verbunden. Lediglich die Ecken an dem Stoßpunkt A weisen keine Stifte auf. In der Fig. 27 sind lediglich die Langlöcher 155a, 155a' und 155a" mit Bezugszeichen versehen, deren Längsachsen den Punkt B1 definieren. Die Langlöcher der übrigen drei Abschnitte sind der Übersichtlichkeit halber nicht mit Bezugszeichen versehen.

Die Stifte 1519a bis 1519d" sind in den Langlöchern 155a, 155a' und 155a" der Stempelführungsplatte 15 angeordnet, die so ausgerichtet sind, dass Ihre Längsachsen sich in einem Nullpunkt B1, B2, B3 oder B4 schneiden. Im kalten Zustand entsprechen diese Punkte B1, B2, B3, B4 jeweils dem Mittelpunkt der Teile 19a, 19b, 19c, 19d der Zylinderplatte 19. Die Anordnung der Langlöcher 155a, 155a' und 155a" und Stifte 1519a bis 1519d" der Stempelführungsplatte 15 ermöglicht dabei eine hervorragende Kompensation der unterschiedlichen Wärmedehnungen zwischen Zylinderplatte 19 (den vier Teilen 19a, 19b, 19c, 19d) und der Stempelführungsplatte 15. Aufgrund der Bestimmung der Nullpunkte B1, B2, B3, B4 der Stempelführungsplatte 15 ist nämlich sichergestellt, dass sich die Nullpunkte relativ zu ihrem entsprechenden Punkt der Zylinderplatte nicht verschieben. Dadurch ist unabhängig von der Wärmedehnung eine exakte Druckausübung auf den Stempel 11 möglich.

Somit ist jederzeit sichergestellt, dass auch bei einer Wärmedehnung der einzelnen Platten 15, 19 während des Betriebs, Positionen der Stempel 11 immer hinreichend genau den entsprechenden Positionen der Bauteile auf dem Substrat entsprechen, wodurch Fehlerzeugnisse vermieden werden können.

Während die Erfindung anhand von einer derzeit bevorzugten Ausführungsform beschrieben wurde, ist festgehalten, dass diese Beschreibung der Ausführungsform vor als Erläuterung zum besseren Verständnis dient, aber den Schutzbereich nicht beschränkt.

Beispielsweise ist der Nullpunkt, den die Langlöcher mit den Zylinderstiften definieren, frei wählbar. Während er gemäß Ausführungsform in der Mitte der Zylinderplatte liegt, kann er auch an anderer Stelle definiert sein, falls dies erforderlich ist.

Dies wird einfach erreicht, indem die Ausrichtung der Langlöcher geändert wird, dass sie sich ihre Längsachsen an einer anderen Stelle schneiden. Es kann nämlich bei manchen Anwendungen sinnvoll sein, den Nullpunkt des Werkzeugs an einen bestimmten Punkt des zu pressenden Bauteils zu setzen. In diesem Fall liegen die Längsachsen der Langlöcher nicht auf einer Ecke mit dem Mittelpunkt der Zylinderplatte verbindenden Linie.

In der Ausführungsform sind die Stifte und Löcher als Langlöcher in der Ecke der Zylinderplatte angeordnet. Es kann aber sinnvoll sein, diese auch an andere Stelle im Randbereich der Zylinderplatte anzuordnen, z.B. in der Mitte jeder Seite oder auch mehrere Löcher an jeder Seite der Zylinderplatte.

**Patentansprüche**

1. Zylinderplatte (19) für eine Vorrichtung zum Verbinden eines Bauelements mit einem Substrat, mit einer in zumindest zwei Teile teilbaren Kammer, wobei

   die Zylinderplatte (19) an einem ersten Teil (1) der Kammer vorgesehen ist, und
   in der Zylinderplatte (19) ausgebildet sind:

      eine Zylinderbohrung (118; 118a, 118b, 118c) zur Aufnahme eines hin- und herbeweglichen Kolbens (117), der bei Beaufschlagung mit einem gasförmigen Druckmedium zur Druckübertragung mit einem Stempel (11, 111) in Anlage bringbar ist, um den Stempel gegen einen an einem zweiten Teil (3) vorgesehenen Gegenstempel (31) zu drücken, und
      eine Druckzufuhrleitung (115; 115a, 115b, 115c), über die zur Betätigung des Kolbens (117) ein Druckmedium zu der Zylinderbohrung (118; 118a, 118b, 118c) zuführbar ist,

   **dadurch gekennzeichnet, dass**
   die Zylinderplatte (19) mittels additiver Fertigung hergestellt ist.

2. Zylinderplatte gemäß Anspruch 1, wobei in der Zylinderplatte (19) eine Vielzahl Zylinderbohrungen (118) mit darin aufgenommenen hin- und herbeweglichen Kolben (117) vorgesehen ist, und jede Zylinderbohrung über eine in der Zylinderplatte ausgebildete Druckzufuhrleitung (115; 115a, 115b, 115c) mit einem Druckmedium versorgbar ist.

3. Zylinderplatte gemäß Anspruch 1 oder 2, wobei

   in der Zylinderplatte (19) eine Vielzahl Zylinderbohrungen (118a, 118b, 118c) vorgesehen ist, und einzelne Zylinderbohrungen (118a, 118b, 118c) zu Gruppen zusammengefasst sind, und die Zylinderbohrungen (118a, 118b, 118c) einer Gruppe über eine eigene in der Zylinderplatte (19) ausgebildete Druckzufuhrleitung (115a, 115b, 115c) mit einem Druckmedium versorgbar sind.

4. Zylinderplatte gemäß einem der Ansprüche 1 bis 3, wobei mehrere Druckzufuhrleitungen (115a, 115b, 115c) in einer einzigen Ebene der Zylinderplatte (19) vorgesehen sind, und Schnitte oder Kreuzungen (115a:115b, 115a:115c, 115c:115b) von zwei unterschiedlichen Druckzufuhrleitungen durch Umgehen der ersten Druckzufuhrleitung (115b; 115c) durch die zweite Druckzufuhrleitung (115a; 115c; 115a) über eine zweite Ebene der Zylinderplatte (19) vermieden sind.

5. Zylinderplatte gemäß einem der Ansprüche 1 bis 4, wobei

zumindest ein Abschnitt der Druckzufuhrleitung (115; 115a, 115b, 115c) von einer geradlinigen Form abweichend ausgebildet ist.

6. Zylinderplatte gemäß einem der Ansprüche 1 bis 5, wobei

die Druckzufuhrleitung (115) einen kreisförmigen oder einen von einer Kreisform abweichenden Querschnitt aufweist.

7. Zylinderplatte gemäß einem der Ansprüche 1 bis 6, wobei

die Druckzufuhrleitung (115) einen Durchmesser zwischen 0,1 mm und 1 mm aufweist.

8. Zylinderplatte gemäß einem der Ansprüche 1 bis 7, wobei

die Zylinderplatte (19) aus Aluminium oder einer Aluminiumlegierung gefertigt ist.

9. Zylinderplatte gemäß einem der Ansprüche 1 bis 8, wobei

die Zylinderplatte mehrere Teile (19a, 19b, 19c 19d) umfasst.

10. Zylinderplatte gemäß einem der Ansprüche 1 bis 9, wobei

die Zylinderplatte (19; 19a, 19b, 19c, 19d) in Eckbereichen Löcher (195a, 195b, 195c, 195d) zur Lagerung über Stifte (20a, 20b, 20c, 20d) an einem Oberteil (1) einer Vorrichtung zum Verbinden eines Bauelements mit einem Substrat aufweist.

11. Zylinderplatte gemäß Anspruch 10, wobei

die Löcher (195a, 195b, 195c, 195d) als Langlöcher ausgeführt sind, deren Längsachsen einen Schnittpunkt aufweisen, der einen Nullpunkt definiert.

12. Zylinderplatte gemäß Anspruch 11, wobei jede Längsachse auf einer Linie liegt, die die jeweilige Ecke der Zylinderplatte (19; 19a, 19b, 19c, 19d) mit einem Mittelpunkt (A) der Zylinderplatte (19) oder einem Stoßpunkt (A) von mehreren Teilen (19a, 19b, 19c, 19d) der Zylinderplatte verbindet.

13. Vorrichtung zum Verbinden eines Bauelements mit einem Substrat, mit

einer in zumindest zwei Teile teilbaren Kammer, wobei

an einem ersten Teil (1) ein Stempel (11, 111) vorgesehen ist, und
an einem zweiten Teil (3) ein Gegenstempel (31) vorgesehen ist, wobei
das erste Teil (1) mit dem zweiten Teil (3) in Anlage bringbar ist, um die Kammer zu schließen, wobei

der Gegenstempel (31) in einem geöffneten Zustand der Kammer mit Ausgangsstoffen beschickbar ist, und
in einem geschlossenen Zustand der Kammer über den Stempel (11) ein Druck auf die zwischen dem Stempel (11, 111) und dem Gegenstempel (31) vorgesehenen Ausgangsstoffe ausübbar ist, wobei
an dem ersten Teil eine Zylinderplatte gemäß einem der Ansprüche 1 bis 12. vorgesehen ist, und der Druck des gasförmigen Druckmediums in der Druckzufuhrleitung (115; 115a, 115b, 115c) mittels einem Kolben (117) auf den Stempel (11, 111) übertragen wird.

14. Verfahren zur Fertigung einer Zylinderplatte (19) die Zylinderbohrungen (118) aufweist, die über eine Druckzufuhrleitung (115) mit einem Anschluss (193) in Verbindung sind, wobei

die Zylinderplatte (19) durch schichtweises Auftragen eines sich nach dem Auftragen verfestigenden Materials auf eine Fertigungsfläche additiv gefertigt wird,
wobei die Zylinderbohrungen (118) und die Druckzufuhrleitungen (115) beim Auftragen des Materials ausgespart werden.

15. Verfahren nach Anspruch 14, wobei
die Druckzufuhrleitungen (115, 115a, 115b, 115c) in einer einzigen Ebene der Zylinderplatte liegen, und Schnitte oder Kreuzungen von zwei unterschiedlichen Druckzufuhrleitungen (115a: 115b; 115a, 115c; 115c; 115b) durch Umgehen von einer Druckzufuhrleitung (115b; 115c) durch die andere Druckzufuhrleitung (115a; 115a, 115c) über eine zweite Ebene gefertigt werden.

**Claims**

1. A cylinder plate (19) for a device for connecting a component to a substrate, comprising a chamber that can be divided into at least two parts, wherein

the cylinder plate (19) is provided on a first part (1) of the chamber, and
formed in the cylinder plate (19) are:

a cylinder bore (118; 118a, 118b, 118c) for receiving a reciprocating piston (117) which, when pressurized with a gaseous pressure medium, can be brought into abutment with a punch (11, 111) for pressure transmission so as to press the punch against a counter-punch (31) provided on a second part (3), and

a pressure supply line (115; 115a, 115b, 115c) via which a pressure medium can be supplied to the cylinder bore (118; 118a, 118b, 118c) to actuate the piston (117),

**characterized in that**
the cylinder plate (19) is manufactured by additive manufacturing.

2. The cylinder plate according to claim 1, wherein a plurality of cylinder bores (118) are provided in the cylinder plate (19), with reciprocating pistons (117) received therein, and each cylinder bore can be supplied with a pressure medium via a pressure supply line (115; 115a, 115b, 115c) formed in the cylinder plate.

3. The cylinder plate according to claim 1 or 2, wherein

a plurality of cylinder bores (118a, 118b, 118c) are provided in the cylinder plate (19), and individual cylinder bores (118a, 118b, 118c) are grouped together, and

the cylinder bores (118a, 118b, 118c) of a group can be supplied with a pressure medium via a separate pressure supply line (115a, 115b, 115c) formed in the cylinder plate (19).

4. The cylinder plate according to any one of claims 1 to 3, wherein multiple pressure supply lines (115a, 115b, 115c) are provided in a single plane of the cylinder plate (19), and intersections or crossings (115a:115b, 115a:115c, 115c:115b) of two different pressure supply lines are avoided by bypassing the first pressure supply line (115b; 115c) by the second pressure supply line (115a; 115c; 115a) via a second plane of the cylinder plate (19).

5. The cylinder plate according to any one of claims 1 to 4, wherein at least one portion of the pressure supply line (115; 115a, 115b, 115c) is formed in a shape deviating from a straight shape.

6. The cylinder plate according to any one of claims 1 to 5, wherein the pressure supply line (115) has a circular cross-section or a cross-section deviating from a circular shape.

7. The cylinder plate according to any one of claims 1 to 6, wherein the pressure supply line (115) has a diameter between 0.1 mm and 1 mm.

8. The cylinder plate according to any one of claims 1 to 7, wherein the cylinder plate (19) is made of aluminum or an aluminum alloy.

9. The cylinder plate according to any one of claims 1 to 8, wherein the cylinder plate comprises multiple parts (19a, 19b, 19c, 19d).

10. The cylinder plate according to any one of claims 1 to 9, wherein the cylinder plate (19; 19a, 19b, 19c, 19d) includes holes (195a, 195b, 195c, 195d) in corner regions for supporting via pins (20a, 20b, 20c, 20d) on an upper part (1) of a device for connecting a component to a substrate.

11. The cylinder plate according to claim 10, wherein the holes (195a, 195b, 195c, 195d) are designed as elongated holes the longitudinal axes of which have an intersection point that defines a zero point.

12. The cylinder plate according to claim 11, wherein each longitudinal axis lies on a line connecting the respective corner of the cylinder plate (19; 19a, 19b, 19c, 19d) to a center point (A) of the cylinder plate (19) or a contact point (A) of multiple parts (19a, 19b, 19c, 19d) of the cylinder plate.

13. Device for connecting a component to a substrate, comprising

a chamber which can be divided into at least two parts, wherein

a punch (11, 111) is provided on a first part (1), and
a counter-punch (31) is provided on a second part (3), wherein
the first part (1) can be brought into abutment with the second part (3) to close the chamber, wherein

the counter-punch (31) can be loaded with starting materials in an open state of the chamber, and
in a closed state of the chamber pressure can be exerted via the punch (11) on the starting materials provided between the punch (11, 111) and the counter-punch (31), wherein
a cylinder plate according to any one of claims 1 to 12 is provided on the first part, and the pressure of the gaseous pressure medium in the pressure supply line (115; 115a, 115b, 115c) is transmitted to the punch (11, 111) by means of a piston (117).

14. A method for manufacturing a cylinder plate (19) having cylinder bores (118) that are connected via a pressure supply line (115) to a port (193), wherein

the cylinder plate (19) is additively manufactured by applying a material that solidifies after application in layers onto a manufacturing surface, wherein the cylinder bores (118) and the pressure supply lines (115) are left out during the application of the material.

15. The method according to claim 14, wherein the pressure supply lines (115, 115a, 115b, 115c) lie in a single plane of the cylinder plate, and intersections or crossings of two different pressure supply lines (115a:115b; 115a, 115c; 115c; 115b) are formed by bypassing one pressure supply line (115b; 115c) by the other pressure supply line (115a; 115a, 115c) via a second plane.

**Revendications**

1. Plaque cylindrique (19) pour un dispositif destiné à relier un composant à un substrat, comportant une chambre divisible en au moins deux parties, dans laquelle

la plaque cylindrique (19) est prévue sur une première partie (1) de la chambre, et dans la plaque cylindrique (19) sont formés :

un alésage cylindrique (118 ; 118a, 118b, 118c) destiné à recevoir un piston (117) à mouvement alternatif qui, lorsqu'il est soumis à un fluide sous pression gazeux, peut être mise en appui avec un poinçon (11, 111) pour la transmission de pression, afin de presser le poinçon contre un contre-poinçon (31) prévu sur une seconde partie (3), et
une conduite d'alimentation en pression (115 ; 115a, 115b, 115c) par laquelle un fluide sous pression peut être acheminé vers l'alésage cylindrique (118 ; 118a, 118b, 118c) afin d'actionner le piston (117),

**caractérisée en ce que**
la plaque cylindrique (19) est fabriquée par fabrication additive.

2. Plaque cylindrique selon la revendication 1, dans laquelle

dans la plaque cylindrique (19) est prévue une pluralité d'alésages cylindriques (118) dans lesquels sont logés des pistons (117) à mouvement alternatif, et chaque alésage cylindrique peut être alimenté en fluide sous pression par l'intermédiaire d'une conduite d'alimentation en pression (115 ; 115a, 115b, 115c) formée dans la plaque cylindrique.

3. Plaque cylindrique selon la revendication 1 ou 2, dans laquelle

une pluralité d'alésages cylindriques (118a, 118b, 118c) est prévue dans la plaque cylindrique (19), et des alésages cylindres (118a, 118b, 118c) individuels sont regroupés, et
les alésages cylindriques (118a, 118b, 118c) d'un groupe peuvent être alimentés en fluide sous pression par l'intermédiaire d'une conduite d'alimentation en pression (115a, 115b, 115c) propre, formée dans la plaque cylindrique (19).

4. Plaque cylindrique selon l'une des revendications 1 à 3, dans laquelle plusieurs conduites d'alimentation en pression (115a, 115b, 115c) sont prévues dans un seul plan de la plaque cylindrique (19), et
des intersections ou croisements (115a:115b, 115a:115c, 115c:115b) de deux conduites d'alimentation en pression différentes sont évitées en contournant la première conduite d'alimentation en pression (115b ; 115c) par la seconde conduite d'alimentation en pression (115a ; 115c; 115a) via un second plan de la plaque cylindrique (19).

5. Plaque cylindrique selon l'une des revendications 1 à 4, dans laquelle
au moins une partie de la conduite d'alimentation en pression (115 ; 115a, 115b, 115c) est formée de manière à s'écarter d'une forme rectiligne.

6. Plaque cylindrique selon l'une des revendications 1 à 5, dans laquelle
la conduite d'alimentation en pression (115) présente une section transversale circulaire ou déviant d'une forme circulaire.

7. Plaque cylindrique selon l'une des revendications 1 à 6, dans laquelle
la conduite d'alimentation en pression (115) a un diamètre compris entre 0,1 mm et 1 mm.

8. Plaque cylindrique selon l'une des revendications 1 à 7, dans laquelle
la plaque cylindrique (19) est fabriquée en aluminium ou en alliage d'aluminium.

9. Plaque cylindrique selon l'une des revendications 1 à 8, dans laquelle
la plaque cylindrique comprend plusieurs parties (19a, 19b, 19c, 19d).

10. Plaque cylindrique selon l'une des revendications 1 à 9, dans laquelle
la plaque cylindrique (19 ; 19a, 19b, 19c, 19d) comprend, dans ses zones d'angle, des trous (195a, 195b, 195c, 195d) pour le support, par l'intermédiaire de goupilles (20a, 20b, 20c, 20d), sur une partie supérieure (1) d'un dispositif destiné à relier un composant à un substrat.

11. Plaque cylindrique selon la revendication 10, dans laquelle
les trous (195a, 195b, 195c, 195d) sont réalisés sous forme de trous oblongs dont les axes longitudinaux présentent un point d'intersection qui définit un point zéro.

12. Plaque cylindrique selon la revendication 11, dans laquelle chaque axe longitudinal est situé sur une ligne reliant le coin respectif de la plaque cylindrique (19 ; 19a, 19b, 19c, 19d) à un centre (A) de la plaque cylindrique (19) ou à un point de contact (A) de plusieurs parties (19a, 19b, 19c, 19d) de la plaque cylindrique.

13. Dispositif pour relier un composant à un substrat, comprenant

une chambre divisible en au moins deux parties, dans laquelle

un poinçon (11, 111) est prévu sur une première partie (1), et
un contre-poinçon (31) est prévu sur une seconde partie (3), dans laquelle
la première partie (1) peut être mise en appui avec la seconde partie (3) afin de fermer la chambre, dans laquelle

le contre-poinçon (31) peut être alimenté en matières premières lorsque la chambre est ouverte, et
lorsque la chambre est fermée, une pression peut être exercée par le poinçon (11) sur les matières premières situées entre le poinçon (11, 111) et le contre-poinçon (31), dans laquelle
une plaque cylindrique selon l'une des revendications 1 à 12 est prévue sur la première partie, et la pression du fluide sous pression gazeux dans la conduite d'alimentation en pression (115 ; 115a, 115b, 115c) est transmise au poinçon (11, 111) au moyen d'un piston (117).

14. Procédé de fabrication d'une plaque cylindrique (19) comprenant des alésages cylindriques (118) qui sont reliés à un raccord (193) par l'intermédiaire d'une conduite d'alimentation en pression (115), dans lequel

la plaque cylindrique (19) est fabriquée de manière additive par application couche par couche d'un matériau se solidifiant après application sur une surface de fabrication,
les alésages cylindriques (118) et les conduites d'alimentation en pression (115) étant épargnés lors de l'application du matériau.

15. Procédé selon la revendication 14, dans lequel
les conduites d'alimentation en pression (115, 115a, 115b, 115c) se trouvent dans un seul plan de la plaque cylindrique, et les intersections ou croisements de deux conduites d'alimentation en pression différentes (115a : 115b ; 115a, 115c ; 115c ; 115b) sont réalisés en contournant une conduite d'alimentation en pression (115b ; 115c) par l'autre conduite d'alimentation en pression (115a ; 115a, 115c) via un second plan.

# Fig. 1

Fig. 2a

Fig. 2b

Fig. 3a

Fig. 3b

Fig. 4a    Fig. 4b

Fig. 5

Fig. 6

Fig. 7a

Fig. 7b

Fig. 7c

Fig. 8

Fig. 9

Fig. 10

Stand der Technik

## Fig. 11

Stand der Technik

## Fig. 12

Stand der Technik

A-A

Fig. 13

EP 4 641 628 B1

## Fig. 14

## Fig. 15

A-A

Fig. 16

## Fig. 17

## Fig. 18

A-A

Fig. 19

Stand der Technik

## Fig. 20

Stand der Technik

## Fig. 20a

Stand der Technik

A-A

## Fig. 20b

Stand der Technik

193a

118

118

118

191b

191a

118

191b

118

118

B-B

## Fig. 20c

193a 193b

Stand der Technik

118

191c

118

118

118

C-C

Fig. 21

## Fig. 22

## Fig. 23

A-A

## Fig. 24

## Fig. 25

# Fig. 26

# Fig. 27

A-A

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102013101124
- DE 102015120156 A1
- JP H11121532 A
- EP 2954550 B1